# EUROPEAN PATENT APPLICATION

(11) **EP 2 290 693 A1**
(43) Date of publication of application: **02.03.2011**
(21) Application number: 09754424.1
(22) Date of filing: 26.05.2009
(51) Int. Cl.: H01L 27/146, G09F 9/30, H01L 21/336, H01L 29/786

(54) **SEMICONDUCTOR DEVICE AND MANUFACTURING METHOD THEREOF**

(30) Priority: 29.05.2008 JP 2008141536
(71) Applicant: Sharp Kabushiki Kaisha, Osaka-shi, Osaka 545-8522 (JP)
(72) Inventor: MAKITA, Naoki, Osaka 545-8522 (JP)
(74) Representative: Goddar, Heinz J.
(86) International application number: PCT/JP2009/002308
(87) International publication number: WO 2009/144915

(57) **Abstract**

A semiconductor device includes a thin-film transistor **126** and a thin-film diode **127.** The respective semiconductor layers **109t** and **109d** of the thin-film transistor **126** and the thin-film diode **127** are portions of a single crystalline semiconductor layer obtained by crystallizing the same amorphous semiconductor film. The semiconductor layer **109t** of the thin-film transistor **126** does include a catalyst element that promotes crystallization of the amorphous semiconductor film. But the semiconductor layer **109d** of the thin-film diode **127** includes substantially no catalyst elements.

## Description

### TECHNICAL FIELD

The present invention relates to a semiconductor device including a thin-film transistor (TFT) and a thin-film diode (TFD) and a method for fabricating such a device.

### BACKGROUND ART

Recently, a semiconductor device including a thin-film transistor (TFT) and a thin-film diode (TFD) on the same substrate and electronic devices with such a semiconductor device have been developed. Such a semiconductor device can be fabricated by making the respective semiconductor layers of the TFT and TFD of the same crystalline semiconductor film on the substrate.

The device characteristics of the TFT and TFD on the same substrate are affected most significantly by the degree of crystallinity of the semiconductor layer to be their active regions. To make a crystalline semiconductor layer of quality on a glass substrate, it is most common to crystalline an amorphous semiconductor film by irradiating it with a laser beam. According to another method, the amorphous semiconductor film may be heated and crystallized after a catalyst element that promotes its crystallization has been added thereto. A third method is to crystallize the amorphous semiconductor film by the latter method and then irradiate the resultant crystalline semiconductor film with a laser beam to further increase its degree of crystallinity. As a result, compared to a normal crystalline semiconductor film that has been crystallized just by being irradiated with a laser beam after having gone through a low-temperature heat treatment process for only a short time, a semiconductor film of better quality, of which the crystallographic plane orientations are aligned to a higher degree, can be obtained.

Patent Document No. 1 discloses an image sensor including, on the same substrate, a photosensor section that uses a TFD and a driver that uses a TFT. According to Patent Document No. 1, the respective semiconductor layers of the TFT and TFD are obtained by crystallizing an amorphous semiconductor film that has been deposited on a substrate.

If the TFT and TFD form integral parts of a single semiconductor device on the same substrate in this manner, not just the overall size of the semiconductor device but also the number of required parts can be reduced, thus cutting down the cost significantly. On top of that, products with new functions, which could not be achieved by conventional combinations of parts, can also be provided.

On the other hand, Patent Document No. 2 discloses a technique for using the same semiconductor film of silicon to form a TFT of crystalline silicon (which will be referred to herein as a "crystalline silicon TFT") and a TFD of amorphous silicon (which will be referred to herein as an "amorphous silicon TFD") on the same substrate. Specifically, a catalyst element that promotes the crystallization of amorphous silicon is added to only a portion of the amorphous silicon film on the substrate to be the active region of the TFT. After that, a heat treatment process is carried out, thereby obtaining a silicon film, of which only the portion to be the active region of the TFT has been crystallized but a portion to be the TFD remains amorphous. By using such a silicon film, the crystalline silicon TFT and the amorphous silicon TFD can be fabricated on the same substrate more easily.

### CITATION LIST

### PATENT LITERATURE

Patent Document No. 1: Japanese Patent Application Laid-Open Publication No. 6-275808
Patent Document No. 2: Japanese Patent Application Laid-Open Publication No. 6-275807

### SUMMARY OF INVENTION

### TECHNICAL PROBLEM

If the respective semiconductor layers of the TFT and TFD are obtained by crystallizing the same amorphous semiconductor film as disclosed in Patent Document No. 1, it is difficult to realize the device characteristics required for the TFT and TFD at the same time. That is to say, the TFT and TFD are required to have different device characteristics according to their applications. According to Patent Document No. 1, however, the amorphous semiconductor film is crystallized by heating it after a catalyst element has been added thereto. In other words, the same crystalline semiconductor film is patterned into semiconductor layers for the TFT and the TFD. However, the present inventors discovered via experiments and researches that it is difficult for both of the TFT and the TFD obtained by the method disclosed in Patent Document No. 1 to meet their required device characteristics at the same time.

On the other hand, if only a portion of the same amorphous semiconductor film is selectively crystallized as in Patent Document No. 2 to form a crystalline silicon TFT of the crystallized portion and an amorphous silicon TFD of the remaining amorphous portion of the film, it is certainly possible to improve the characteristics of the crystalline silicon TFT by controlling the crystal growing conditions. But the characteristics of the amorphous silicon TFD cannot be improved sufficiently. This is because if an amorphous silicon TFD is fabricated by the method of Patent Document No. 2, some of the hydrogen atoms originally included in the amorphous silicon film will be lost during the process step of crystallizing the portion of the amorphous silicon film into crystalline silicon. As a result, an amorphous silicon TFD with good electrical characteristics cannot be obtained. Specifically, in an amorphous silicon film as deposited, silicon atoms are tightly bonded with hydrogen atoms, thus leaving no dangling bonds at all. However, during the annealing process to crystallize the amorphous silicon film, their bonds are broken, and some hydrogen atoms are lost, thus turning the amorphous silicon film into an amorphous silicon of poor quality with a lot of dangling bonds. Although some of those dangling bonds will be recombined with hydrogen atoms during the hydrogenation process to be carried out later, the good bonding state of the amorphous silicon film as deposited can no longer be recovered. Consequently, the device characteristics of the amorphous silicon TFD become inferior to those of the crystalline silicon TFD with the crystalline semiconductor layer. Also, even if an amorphous silicon TFD with good characteristics could be obtained by any chance, its photosensitivity would be certainly higher than that of a crystalline silicon TFD but the amount of forward current flowing through such a device would not be large enough to use it as a kind of photosensor. For instance, in real-time image sensing, while a single picture is being scanned, not only photosensing but also a reset of the TFD potential to get ready for the next scan need to be done. With an amorphous silicon TFD with a low field-effect mobility, however, that reset scanning could not be done in time. That is to say, considering their overall device performances, it must be said that a crystalline silicon TFD that uses a crystalline semiconductor layer is still superior to the amorphous silicon TFD.

It is therefore an object of the present invention to optimize, according to required device characteristics, the respective semiconductor layers of a TFT and TFD that have been formed by crystallizing the same amorphous semiconductor film.

### SOLUTION TO PROBLEM

A semiconductor device according to the present invention includes a thin-film transistor and a thin-film diode. The thin-film transistor includes a semiconductor layer that has a channel region, a source region and a drain region, a gate electrode that controls the conductivity of the channel region, and a gate insulating film arranged between the semiconductor layer and the gate electrode. The thin-film diode includes a semiconductor layer that has at least an n-type region and a p-type region. The respective semiconductor layers of the thin-film transistor and the thin-film diode are portions of a single crystalline semiconductor layer obtained by crystallizing the same amorphous semiconductor film. The semiconductor layer of the thin-film transistor does include a catalyst element that promotes crystallization of the amorphous semiconductor film. The semiconductor layer of the thin-film diode includes substantially no catalyst elements.

In one preferred embodiment, the semiconductor layer of the thin-film diode is comprised mostly of crystals with (100) and/or (111) plane orientations.

In another preferred embodiment, the thin-film diode further has an intrinsic region that is defined between the n- and p-type regions of the semiconductor layer of the thin-film diode and that is comprised mostly of crystals with (100) and/or (111) plane orientations.

In still another preferred embodiment, at least the channel region of the semiconductor layer of the thin-film transistor is comprised mostly of crystals, of which the plane orientations are defined by a <111> zone.

In this particular preferred embodiment, at least the channel region of the semiconductor layer of the thin-film transistor is comprised mostly of crystals with (110) and/or (211) plane orientations.

At least the channel region of the semiconductor layer of the thin-film transistor is preferably comprised of a group of columnar crystals, of which the crystal-growing direction is preferably roughly parallel to the direction in which carriers move in the thin-film transistor.

In the semiconductor layer of the thin-film transistor, the catalyst element may not be deposited but included as a solid solution.

In the semiconductor layer of the thin-film transistor, the concentration of the catalyst element may be higher in the source or drain region than in the channel region.

The thin-film transistor may further include a gettering region, which is defined elsewhere in the semiconductor layer of the thin-film transistor so as not to overlap with the channel, source or drain region, and the concentration of the catalyst element may be higher in the gettering region than in the channel, source or drain region.

The thin-film transistor may be a number of thin-film transistors including an n-channel thin-film transistor and a p-channel thin-film transistor.

The catalyst element may be nickel.

A method for fabricating a semiconductor device according to the present invention includes the steps of: (a) providing a substrate, of which the surface is covered with an amorphous semiconductor film; (b) selectively adding a catalyst element, which promotes crystallization, to only a part of the amorphous semiconductor film; (c) heating the amorphous semiconductor film, to which the catalyst element has been added selectively, thereby crystallizing that part of the amorphous semiconductor film to define a catalyst-aided crystallized region and leaving the rest of the amorphous semiconductor film as an amorphous region; (d) irradiating the catalyst-aided crystallized region and the amorphous region with a laser beam, thereby obtaining a crystalline semiconductor film that has a high crystallinity region, which has been defined by either further crystallizing or re-crystallizing the catalyst-aided crystallized region, and a low crystallinity region, which has been defined by crystallizing the amorphous region; and (e) patterning the crystalline semiconductor film into a first semiconductor island to define an active region for the thin-film transistor and a second semiconductor island to define an active region for the thin-film diode. The first layer includes the high crystallinity region, and the second layer includes the low crystallinity region.

In one preferred embodiment, the step (c) includes defining the catalyst-aided crystallized region by crystallizing that part of the amorphous semiconductor film to which the catalyst element has been added.

In another preferred embodiment, the step (c) includes the steps of: (c1) crystallizing that part of the amorphous semiconductor film, to which the catalyst element has been added, thereby defining a first catalyst-aided crystallized region; and (c2) growing crystals laterally from the first catalyst-aided crystallized region, thereby defining a second catalyst-aided crystallized region around the first catalyst-aided crystallized region. The step (d) includes the step of defining a first high crystallinity region by either further crystallizing or re-crystallizing the first catalyst-aided crystallized region and defining a second high crystallinity region by either further crystallizing or re-crystallizing the second catalyst-aided crystallized region. In the step (e), the first semiconductor island includes the second high crystallinity region.

The step (e) may include defining a portion of the first semiconductor island to be the channel region of a thin-film transistor out of the high crystallinity region of the crystalline semiconductor film.

The step (e) may include defining a portion of the second semiconductor island to be the intrinsic region of a thin-film diode out of the low crystallinity region of the crystalline semiconductor film.

The step (e) may include forming the first semiconductor island in its entirety out of the high crystallinity region of the crystalline semiconductor film.

The step (e) may include forming the second semiconductor island in its entirety out of the low crystallinity region of the crystalline semiconductor film.

The step (e) may include defining at least partially a region of the first semiconductor island to be the source region and/or the drain region of a thin-film transistor out of the first high crystallinity region of the crystalline semiconductor film and defining a region of the first semiconductor island to be the channel region of the thin-film transistor out of the second high crystallinity region.

The step (e) may include forming a semiconductor layer to be one of the two electrodes of a capacitor out of the low crystallinity region of the crystalline semiconductor film.

The step (e) may further include forming another semiconductor island to be the active region of another thin-film transistor out of the low crystallinity region of the crystalline semiconductor film.

In one preferred embodiment, the step (b) includes: covering the amorphous semiconductor film with a mask that has an opening; and adding the catalyst element to a selected region of the amorphous semiconductor film through the opening.

The step (d) preferably includes irradiating the catalyst-aided crystallized region and the amorphous region with a laser beam having such an energy density that is not so high as to totally reset the degree of crystallinity of the catalyst-aided crystallized region yet to be irradiated with the laser beam but is high enough to crystallize the amorphous region.

The substrate may transmit light, and the method further includes, before the step (a), forming an opaque layer for cutting off light that has come through the back surface of the substrate under a region of the substrate in which the second semiconductor island to be the active region of a thin-film diode will be formed.

In another preferred embodiment, the method further includes the steps of: (f) forming a gate insulating film that covers at least the first semiconductor island; (g) forming a gate electrode on the gate insulating film that covers the first semiconductor island; (h) doping portions of the first semiconductor island, which will be source and drain regions, with a dopant element; (i) doping a portion of the second semiconductor island, which will be an n-type region, with an n-type dopant element; and (j) doping another portion of the second semiconductor island, which will be a p-type region, with a p-type dopant element.

In one preferred embodiment of the semiconductor device of the present invention, at least the channel region of the semiconductor layer of the thin-film transistor is a crystalline region that has been crystallized by getting annealed with a catalyst element that promotes the crystallization of the amorphous semiconductor film added.

The semiconductor layer of the thin-film diode is preferably a crystalline region that has been crystallized without using the catalyst element. Alternatively, the semiconductor layer of the thin-film diode may be a crystalline semiconductor layer obtained by irradiating the amorphous semiconductor film with a laser beam and crystallizing it.

In another preferred embodiment, the semiconductor layer of the thin-film transistor is comprised of columnar crystals and the semiconductor layer of the thin-film diode includes substantially no columnar crystals.

The semiconductor layer of the thin-film transistor may include continuous grain silicon (which is also called "CG silicon") and the semiconductor layer of the thin-film diode may include polysilicon.

In one preferred embodiment, the semiconductor layer of the thin-film transistor includes a high crystallinity region, which is defined by heating the amorphous semiconductor film with the catalyst element added to crystallize it and then irradiating the crystallized semiconductor film with a laser beam to further crystallize or re-crystallize it. At least the channel region of the semiconductor layer of the thin-film transistor is defined in this high crystallinity region.

In one preferred embodiment of a semiconductor device manufacturing process according to the present invention, the step (h) may include doping portions of the first semiconductor island to be source and drain regions with an n-type dopant element and the steps (h) and (i) may be performed simultaneously. Alternatively, the step (h) may include doping portions of the first semiconductor island to be source and drain regions with a p-type dopant element and the steps (h) and (j) may be performed simultaneously.

The first semiconductor island may be islands of semiconductor regions including an island to be the active region of an n-channel thin-film transistor and an island to be the active region of a p-channel thin-film transistor. The step (h) may include the steps of: (h1) doping the semiconductor island to be the n-channel thin-film transistor, which is one of the islands of semiconductor regions in the first semiconductor island, with an n-type dopant element; and (h2) doping the semiconductor island to be the p-channel thin-film transistor with a p-type dopant element. The steps (h1) and (i) may be performed simultaneously, and the steps (h2) and (j) may be performed simultaneously.

Another semiconductor device according to the present invention is fabricated by any of the methods of the present invention described above.

An electronic device according to the present invention includes a semiconductor device according to any of the preferred embodiments of the present invention described above. The electronic device of the present invention may include one or both of a display unit and a photosensor unit.

The display unit may include the thin-film transistor and the photosensor unit may include the thin-film diode.

The photosensor unit may be an ambient sensor for adjusting the luminance of the display unit. Alternatively, the photosensor unit may also be a touchscreen panel sensor for the display unit.

A display device according to the present invention includes: a display area with a number of display units; and a frame area surrounding the display area. The display device further includes at least one photosensor unit with a thin-film diode. Each said display unit includes an electrode and a thin-film transistor connected to the electrode. The thin-film transistor and the thin-film diode are arranged on the same substrate. The thin-film transistor includes: a semiconductor layer that has a channel region, a source region and a drain region; a gate electrode that controls the conductivity of the channel region; and a gate insulating film arranged between the semiconductor layer and the gate electrode. The thin-film diode includes a semiconductor layer with an n-type region, a p-type region and an intrinsic region interposed between the n- and p-type regions. The respective semiconductor layers of the thin-film transistor and the thin-film diode are portions of a single crystalline semiconductor layer obtained by crystallizing the same amorphous semiconductor film. The semiconductor layer of the thin-film transistor does include a catalyst element that promotes crystallization of the amorphous semiconductor film, but the semiconductor layer of the thin-film diode includes substantially no catalyst elements.

In one preferred embodiment, the display device further includes a second crystalline semiconductor layer, which has been formed by crystallizing the same amorphous semiconductor film, and a capacitor that uses the second crystalline semiconductor layer as one of its two electrodes. The second crystalline semiconductor layer includes substantially no catalyst elements.

The second crystalline semiconductor layer may be connected to either the source region or the drain region of the semiconductor layer of the thin-film transistor.

Another display device according to the present invention includes: a display area with a number of display units; and a frame area surrounding the display area. The display device further includes at least one photosensor unit with a thin-film diode. Each said display unit includes an electrode and a first thin-film transistor connected to the electrode. A second thin-film transistor is provided in the frame area to form a driver circuit. The first and second thin-film transistors and the thin-film diode are arranged on the same substrate. Each of the first and second thin-film transistors includes: a semiconductor layer that has a channel region, a source region and a drain region; a gate electrode that controls the conductivity of the channel region; and a gate insulating film arranged between the semiconductor layer and the gate electrode. The thin-film diode includes a semiconductor layer with an n-type region, a p-type region and an intrinsic region interposed between the n- and p-type regions. The respective semiconductor layers of the first and second thin-film transistors and the thin-film diode are portions of a single crystalline semiconductor layer that has been obtained by crystallizing the same amorphous semiconductor film. The respective semiconductor layers of the first and second thin-film transistors do include a catalyst element that promotes crystallization of the amorphous semiconductor film, but the semiconductor layer of the thin-film diode includes substantially no catalyst elements.

still another display device according to the present invention includes: a display area with a number of display units; and a frame area surrounding the display area. The display device further includes at least one photosensor unit with a thin-film diode. Each said display unit includes an electrode and a first thin-film transistor connected to the electrode. A second thin-film transistor is provided in the frame area to form a driver circuit. The first and second thin-film transistors and the thin-film diode are arranged on the same substrate. Each of the first and second thin-film transistors includes: a semiconductor layer that has a channel region, a source region and a drain region; a gate electrode that controls the conductivity of the channel region; and a gate insulating film arranged between the semiconductor layer and the gate electrode. The thin-film diode includes a semiconductor layer with an n-type region, a p-type region and an intrinsic region interposed between the n- and p-type regions. The respective semiconductor layers of the first and second thin-film transistors and the thin-film diode are portions of a single crystalline semiconductor layer that has been obtained by crystallizing the same amorphous semiconductor film. The semiconductor layer of the second thin-film transistor does include a catalyst element that promotes crystallization of the amorphous semiconductor film, but the respective semiconductor layers of the first thin-film transistor and the thin-film diode includes substantially no catalyst elements.

The driver circuit formed by the second thin-film transistor in the frame area may drive the first thin-film transistor that is connected to each said display unit.

The driver circuit formed by the second thin-film transistor in the frame area may drive a photosensor unit including the thin-film diode.

The substrate preferably transmits light. The thin-film diode preferably further includes an opaque layer, which is arranged between the semiconductor layer of the thin-film diode and the substrate. And when viewed from under the back surface of the substrate, the opaque layer is preferably arranged so as to overlap at least the intrinsic region of the semiconductor layer of the thin-film diode.

The display device may further include a backlight.

The display device may includes multiple photosensor units, each of which may be arranged in the display area so as to be associated with either one or two or more of the display units.

The backlight may include a backlight controller for controlling the intensity of the light emitted from the backlight. The photosensor unit may be arranged in the frame area, generate an illuminance signal representing the illuminance of external light, and output it to the backlight controller.

### ADVANTAGEOUS EFFECTS OF INVENTION

According to the present invention, in a semiconductor device including a TFT and a TFD on the same substrate, the semiconductor layers of the TFT and the TFD are optimized to meet their device performances required. Consequently, the present invention provides a semiconductor device including a TFT and a TFD with excellent performances.

The present invention can be used effectively in a liquid crystal display device with a sensor function. If the present invention is applied to a liquid crystal display device including a TFT for use to make a driver, a TFT to switch a pixel electrode, and a TFD for use as a photosensor, for example, then a TFT with high field effect mobility and a low threshold voltage and a TFD with a low dark current value and a high SNR with respect to light (i.e., the ratio of the amount of current to flow in bright state to that of current to flow in dark state) can be formed of the same amorphous semiconductor film, which is beneficial. Particularly if the degree of crystallinity is optimized in the channel region that has significant influence on the field effect mobility of the TFT and in the intrinsic region that has great impact on the photosensitivity of the TFD, the best device characteristics are realized for the respective semiconductor components.

In addition, according to the present invention, a high-performance semiconductor device including a TFT and a TFD on the same substrate can be fabricated without increasing the number of manufacturing processing steps or the manufacturing cost. As a result, a product of a smaller size and with improved performance can be provided at a reduced cost.

### BRIEF DESCRIPTION OF DRAWINGS

FIG. **1** is a cross-sectional view schematically illustrating a semiconductor device as a first specific preferred embodiment of the present invention.
FIGS. **2(A)** through **2(I)** are cross-sectional views schematically illustrating respective manufacturing process steps to fabricate the semiconductor device of the first preferred embodiment of the present invention.
FIGS. **3(A)** through **3(F)** are cross-sectional views schematically illustrating respective manufacturing process steps to fabricate a semiconductor device as a second specific preferred embodiment of the present invention.
FIGS. **4 (A)** through **4(E)** are cross-sectional views schematically illustrating respective manufacturing process steps to fabricate a semiconductor device as a third specific preferred embodiment of the present invention.
FIGS. **5(F)** through **5(H)** are cross-sectional views schematically illustrating respective manufacturing process steps to fabricate a semiconductor device as a third specific preferred embodiment of the present invention.
FIGS. **6(I)** through **6(K)** are cross-sectional views schematically illustrating respective manufacturing process steps to fabricate a semiconductor device as a third specific preferred embodiment of the present invention.
FIGS. **7(A)** through **7(E)** are cross-sectional views schematically illustrating respective manufacturing process steps to fabricate a semiconductor device as a fourth specific preferred embodiment of the present invention.
FIGS. **8(A)** through **8(E)** are cross-sectional views schematically illustrating respective manufacturing process steps to fabricate a semiconductor device as a fifth specific preferred embodiment of the present invention.
FIG. **9** is a circuit diagram illustrating a photosensor TFD.
FIG. **10** illustrates a configuration for a photosensing type touchscreen panel.
FIG. **11** is a plan view schematically illustrating the rear substrate of a touchscreen panel LCD as a sixth preferred embodiment of the present invention.
FIG. **12** is a perspective view illustrating a liquid crystal display device with an ambient light sensor according to the sixth preferred embodiment of the present invention.
FIGS. **13(A)** to **13(C)** are graphs showing the amounts of dark and bright currents to flow through a photosensor TFD and its bright current to dark current ratio.

### DESCRIPTION OF EMBODIMENTS

Hereinafter, a semiconductor device as a preferred embodiment of the present invention and a method for fabricating such a device will be described.

A semiconductor device according to a preferred embodiment of the present invention includes a thin-film transistor and a thin-film diode. The thin-film transistor includes a semiconductor layer that has a channel region, a source region and a drain region, a gate insulating film arranged over the semiconductor layer and a gate electrode that controls the conductivity of the channel region. The thin-film diode includes a semiconductor layer that has at least an n-type region and a p-type region. The respective semiconductor layers of the thin-film transistor and the thin-film diode are portions of a single crystalline semiconductor layer obtained by crystallizing the same amorphous semiconductor film. The semiconductor layer of the thin-film transistor does include a catalyst element that promotes crystallization of the amorphous semiconductor film. On the other hand, the semiconductor layer of the thin-film diode includes substantially no catalyst elements.

The semiconductor layer of the thin-film transistor has a crystallized region that has been crystallized with a catalyst element. More specifically, the semiconductor layer has a crystallized region that has been crystallized by adding a metallic element that promotes crystallization (i.e., a catalyst element) to an amorphous semiconductor film and then heating it. Such a crystallized region is made up of continuous grain silicon (which will also be referred to herein as "CG silicon"), of which the crystal grains have aligned orientations. The crystal domain (i.e., a region with substantially the same plane orientation) of CG silicon has a size of approximately 2 to 8 µm, which is greater than the average crystal grain size (which is typically approximately 200 nm) of a low temperature polysilicon (LPS) film that has been obtained by normal laser crystallization. In addition, since the crystal grains have had their crystallographic plane orientations aligned with each other very well, excellent electrical characteristics (e.g., high mobility) are realized.

On the other hand, the semiconductor layer of the thin-film diode has a crystalline region that has been crystallized without using a catalyst element. The semiconductor layer is preferably a crystalline semiconductor layer that has been crystallized by irradiating an amorphous semiconductor film with a laser beam, is made of the low temperature polysilicon (LPS) mentioned above, and has an average crystal grain size of 50 nm to 500 nm, for example. Since such a crystalline semiconductor layer includes substantially no catalyst element as will be described later, a high SNR is realized with the increase in dark current minimized.

Also, the semiconductor layer of the thin-film diode has an intrinsic region, which is located between its n-type and p-type regions and which includes substantially no catalyst elements. Preferably, the semiconductor layer of the thin-film diode has an intrinsic region, which is located between its n-type and p-type regions and which is a crystalline semiconductor layer that has been crystallized by irradiating an amorphous semiconductor film with a laser beam.

In the semiconductor device of this preferred embodiment, each of the TFT and TFD thereof realizes its best device performance. On top of that, since a crystalline semiconductor layer made from the same amorphous semiconductor film is used, a semiconductor device including such a TFT and such a TFD on the same substrate can be obtained by a simple method and a very simple device structure is realized.

Such a crystalline semiconductor layer that has been crystallized with a catalyst element has a high degree of crystallinity, and therefore, has high field effect mobility as well. For that reason, such a crystalline semiconductor layer can be used effectively to make a TFT that should have high field effect mobility and a low threshold voltage for use in a driver. Furthermore, generally speaking, the higher the degree of crystallinity of a semiconductor layer, the smaller the amount of leakage current to flow through a TFT in OFF state and the higher the ON/OFF ratio. That is to say, such a semiconductor layer can also be used effectively to make a TFT to switch a pixel electrode. The same can be said about a TFD. That is to say, the higher the degree of crystallinity, the greater the amount of forward current to flow through the TFD. And it has been believed that even if a TFD is turned OFF with a reverse bias applied to it, the higher the degree of crystallinity, the lower the leakage current value should be.

However, the present inventors obtained quite different results via experiments. Specifically, if the semiconductor layer of a TFD is irradiated with light with a reverse bias applied to the TFD, then the amount of leakage current to flow increases. And by taking advantage of this variation in the amount of current to flow, the TFD can be used as a photosensor. If the leakage current to flow in the dark with a reverse bias applied to the TFD is called "dark current" and the leakage current to flow through the TFD being irradiated with light is called "bright current", the SNR, which is a factor representing the device performance of the TFD, should be the ratio of the bright current to the dark current.

The present inventors compared the characteristics of a crystalline semiconductor layer that had been obtained by crystallizing an amorphous semiconductor film through a heat treatment using a catalyst element to those of a crystalline semiconductor layer that had been obtained by crystallizing the same amorphous semiconductor film without using any catalyst element. The results are shown in FIGS.

### 13 (A) to 13(C).

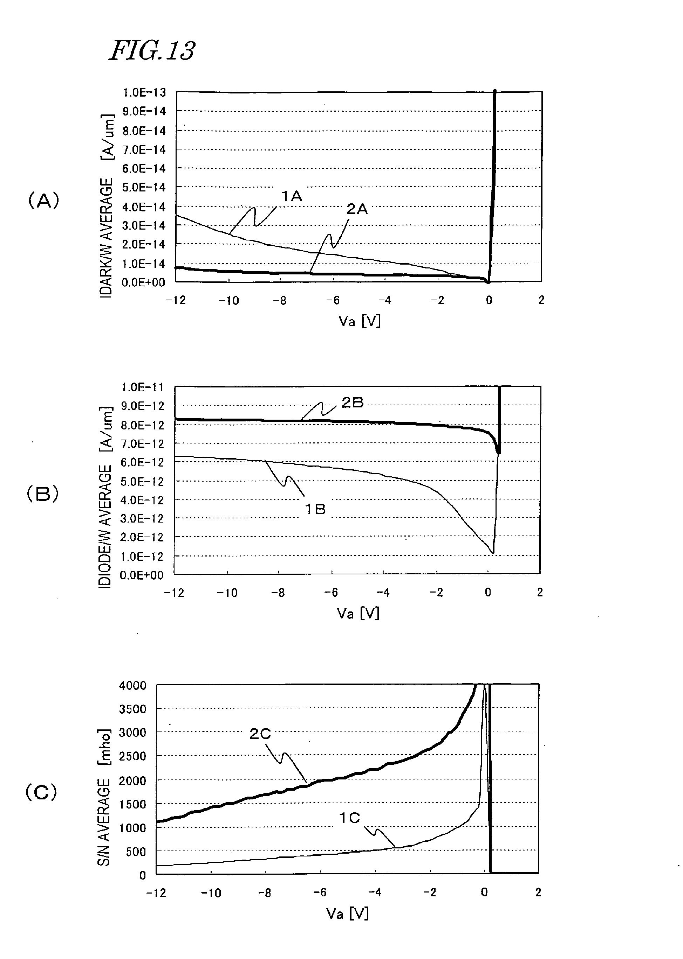

FIG. **13 (A)** is a graph showing how the dark current depends on the anode voltage **Va** to be applied to the TFD. In FIG. **13(A)****,** the abscissa represents the anode voltage **Va,** of which a negative value indicates that a reverse bias is applied to the TFD. On the other hand, the ordinate represents the dark current, which is a current value per unit width that has been standardized with respect to the width **W** of the TFD's semiconductor layer. In FIG. **13(A)****,** the curve **1A** represents the characteristic of a semiconductor layer that was crystallized with a catalyst element, while the curve **2A** represents the characteristic of a semiconductor layer that was crystallized without using any catalyst element.

FIG. **13(B)** is a graph showing how the bright current depends on Va. As in FIG. **13 (A)****,** the abscissa of FIG. **13 (B)** represents the anode voltage **Va** applied to the TFD and the ordinate represents the amount of bright current to flow when the TFD is irradiated with light of 10,000 lux. In this case, the "bright current" is also a current value per unit width that has been standardized with respect to the width **W** of the TFD's semiconductor layer as in the graph shown in FIG. **13(A)****.** In FIG. **13(B)****,** the curve **1B** represents the characteristic of a semiconductor layer that was crystallized with a catalyst element, while the curve **2B** represents the characteristic of a semiconductor layer that was crystallized without using any catalyst element.

FIG. **13(C)** is a graph showing how the bright current to dark current ratio, which is represented as an SNR as the ordinate, depends on Va in these semiconductor layers. In FIG. **13(C)****,** the curve **1C** represents the characteristic of a semiconductor layer that was crystallized with a catalyst element, while the curve **2C** represents the characteristic of a semiconductor layer that was crystallized without using any catalyst element. It can be seen that in any Va range, the semiconductor layer crystallized with a catalyst element (as represented by the curve **1C)** achieved a higher SNR than the semiconductor layer **2C** crystallized without using any catalyst element (as represented by the curve **2C).** Specific values of the dark current, bright current and SNR with respect to the anode voltage are shown in the following Table 1:

**Table 1**

| Crystallized | Anode voltage [V] | -3 | -4 | -5 | -6 | -7 | -8 | -9 |
|---|---|---|---|---|---|---|---|---|
| Without catalyst element | Dark current [A/µm] | 3.3E-15 | 3.6E-15 | 3.9E-15 | 4.1E-15 | 4.4E-15 | 4.8E-15 | 5.2E-15 |
| | Bright current [A/ µm] @10,000 lux | 7.8E-12 | 7.8E-12 | 7.9E-12 | 7.9E-12 | 7.9E-12 | 8. 0E-12 | 8. 0E-12 |
| | SNR | 2368 | 2190 | 2044 | 1933 | 1787 | 1665 | 1528 |
| With catalyst element | Dark current [A/µm] | 1.0E-14 | 1.3E-14 | 1.5E-14 | 1.7E-14 | 2. 0E-14 | 2. 3E-14 | 2.6E-14 |
| | Bright current [A/µm] @10,000 lux | 5.2E-12 | 5.5E-12 | 5.7E-12 | 5.8E-12 | 6. 0E-12 | 6.1E-12 | 6.2E-12 |
| | SNR | 502 | 438 | 385 | 342 | 304 | 270 | 241 |

The value of the anode voltage **Va** applied to a TFD changes according to the type of the electronic device required. For example, in a situation where an anode voltage of -7 V is applied, the semiconductor layer crystallized without using any catalyst element had approximately one-fifth as large dark current as, approximately 1.3 times as large bright current as, and six times as high an SNR as, the semiconductor layer crystallized with a catalyst element. Among other things, the dark current decreased significantly, and the SNR could be increased considerably.

To find how and why these results were obtained, a catalyst element was intentionally added to a semiconductor layer that had been crystallized without using a catalyst element. As a result, the present inventors confirmed that the amount of dark current flowing increased, thus causing serious deterioration. That is to say, the present inventors discovered that the amount of dark current flowing increased due to the presence of the catalyst element, not the degree of crystallinity of the semiconductor layer.

It should be noted that part of the catalyst element that has produced a silicide or any other deposition in the semiconductor layer will be removed by gettering process to be performed after the crystallization. That is why the catalyst element left in the semiconductor layer that has been crystallized with the catalyst element forms a solid solution. Conventional TFTs have never been affected adversely by such a catalyst element in the form of solid solution. It can be seen, however, that a TFD for use as a photosensor could have its performance affected by a catalyst element that forms a solid solution in the semiconductor layer. This is because compared to a TFT, a TFD is required much more strictly to reduce its dark current value as much as possible, and therefore, its leakage current will be affected by a catalyst element too much to avoid producing a sensible defect.

Consequently, according to this preferred embodiment, for a TFT and a TFD, which have been fabricated on the same substrate and of which the semiconductor layers are crystalline semiconductor layers obtained by crystallizing the same amorphous semiconductor film, a TFT with high field effect mobility and a low threshold voltage can be formed using a semiconductor layer that has been crystallized with catalyst element. In addition, a TFD for use as a photosensor, which exhibits high sensitivity with respect to external light and which also has a high SNR (i.e., the ratio of the amount of current to flow in the bright state to that of current to flow in the dark state) with respect to the light, can be formed. In particular, if the channel region that has significant influence on the field effect mobility of a TFT is a region that has been crystallized with a catalyst element and if the intrinsic region that has great impact on the photosensitivity of a TFD is a region that has been crystallized without using any catalyst element, the respective semiconductor components can have their best performances.

These semiconductor layers of the TFT and the TFD can be easily formed separately by selectively adding a catalyst element to an amorphous semiconductor film so that only a region to which the catalyst element has been added is crystallized, while the other regions remain amorphous, which may be crystallized by being irradiated with a laser beam after that. That is to say, the semiconductor layer of the TFD or its intrinsic region is preferably a crystalline semiconductor layer that has been obtained by crystallizing an amorphous semiconductor film with a laser beam.

In that case, if the entire substrate is irradiated with the laser beam, then the portion that has been crystallized by going through a heat treatment with a catalyst element added can also be irradiated with the laser beam and can have its degree of crystallinity increased. That is to say, in this preferred embodiment, the channel region of the semiconductor layer of the TFT is preferably a crystalline semiconductor layer that has been crystallized by going through a heat treatment with a catalyst element, which promotes crystallization of an amorphous semiconductor film, added and than has been re-crystallized with a laser beam. Then, there is no need to perform positioning control on an amorphous region to be irradiated with a laser beam. As a result, the laser irradiation process step can get done by a highly productive simple method.

Also, if an amorphous semiconductor film is crystallized by subjecting it to a heat treatment with a catalyst element added thereto, then a crystalline semiconductor layer can be obtained as a group of microscopic columnar crystals. In this case, if the crystal-growing direction is controlled, the orientations of those columnar crystals can be roughly aligned with each other. Thus, if the channel region in the semiconductor layer of the TFT consists of a group of columnar crystals and if the crystal-growing directions of those columnar crystals are roughly parallel to the directions in which carriers move in the thin-film transistor, a TFT with an even higher degree of current drivability is realized.

In at least the channel region of the semiconductor layer of the TFT, the majority of that region preferably consists of crystals with a <111> zone. Also, in the semiconductor layer of the TFT, at least the channel region thereof preferably consists of crystals with (110) and/or (211) plane orientations. More specifically, even though the majority of the crystalline semiconductor layer consists of crystals with the <111> zone, it is preferred that crystals with (110) and (211) crystallographic plane orientations, among other things, account for 50% or more of the entire crystalline semiconductor layer.

If an amorphous semiconductor film is subjected to a heat treatment with a catalyst element added, then the crystal growth will advance laterally (i.e., parallel to the substrate) in <111> directions because the catalyst element will heavily depend on the crystal-growing direction. As a result, on the surface of the crystalline semiconductor film thus obtained, there will be a group of crystals that have crystallographic plane orientations that are perpendicular to the <111> directions, which form the so-called "<111> zone". Among other things, crystals with (110) and (211) plane orientations are oriented in these directions much more perfectly than crystals with any other plane orientations. In the <111> zone, holes have much higher mobility than in any other zone. That is why the performance of a p-channel TFT, which is usually inferior to that of an n-channel TFT, can be improved particularly significantly. Consequently, it is easy to strike an adequate balance in a semiconductor circuit that uses TFTs. These trends are observed quite clearly in (110) and (211) planes, among other things. For that reason, these crystallographic plane orientations can be used very effectively to make TFTs.

On the other hand, the majority of the semiconductor layer of the TFD preferably consists of crystals with (100) and/or (111) plane orientations. Furthermore, it is preferred that the semiconductor layer of the TFT include an intrinsic region between the n-type and p-type regions thereof and that the majority of the intrinsic region consist of crystals with (100) and/or (111) plane orientations.

Generally speaking, when a crystal-growing process is carried out without using any catalyst element, the crystalline semiconductor layer is often affected by either the insulator (such as amorphous silicon dioxide, among other things) of its undercoat insulating film or its own surface (i.e., the interface with vacuum) and therefore tends to have (111) and/or (100) crystallographic plane orientations, among other things. In that case, it seems that the TFD will achieve high photosensitivity. The dark current shown in FIG. **13(A)** is significantly affected by the presence or concentration of the catalyst element. On the other hand, the bright current shown in FIG. **13(B)** tends to be affected by the crystallographic plane orientations. As a result, by using the semiconductor layer that has been obtained by crystallizing the same amorphous semiconductor film, the TFT and the TFD can achieve their best device performances required.

In this case, in the channel region of the semiconductor layer of the TFT, the catalyst element is preferably contained as solid solution, instead of being deposited. Generally speaking, if a catalyst element contained in a semiconductor layer has a concentration exceeding its solid solubility, then the excessive catalyst element will usually be deposited as a silicide compound. And if a crystal-growing process is carried out using a catalyst element, the catalyst element must be turned into a silicide compound. That is why whenever crystals have grown, a silicide compound will always be left. However, that silicide compound should be removed from the device as a final product because the electrical characteristic of the semiconductor layer of the TFT (e.g., the amount of leakage current to flow through the TFT in OFF state) should be affected by the silicide compound. For that reason, a catalyst element is included in the channel region in the semiconductor layer of the TFT of the present invention but is preferably included as a solid solution, not as deposition.

To get that done, the concentration of the catalyst element in the source or drain region of the semiconductor layer of the TFT is preferably higher than that of the catalyst element in the channel region thereof. Also, the semiconductor layer of the TFT preferably has not only the source/drain regions but also a gettering region as well, and the concentration of the catalyst element in the gettering region is preferably higher than that of the catalyst element in the channel, source or drain region. If such a portion that has been used as the gettering region during the manufacturing process is not removed but left intentionally even after the TFT is completed, the function of gettering (i.e., removing) the catalyst element away from the channel region will be active not only during the manufacturing process but also even after the device is completed.

The catalyst element for use in the crystal-growing process is one or multiple elements to be selected from the group consisting of Ni, Co, Sn, Pb, Pd, Fe and Cu. If one or multiple ones of these elements is/are added even in a very small amount, the crystallization of the amorphous semiconductor film can still be promoted effectively. Among other things, if Ni is used, most significant effects will be achieved.

The thin-film transistor of this preferred embodiment may be either an n-channel thin-film transistor or a p-channel thin-film transistor. Alternatively, the semiconductor device of this preferred embodiment may include multiple thin-film transistors including an n-channel thin-film transistor and a p-channel thin-film transistor. Still alternatively, the semiconductor device of this preferred embodiment may include not only TFT and TFD with the respective degrees of crystallinity described above but also other TFTs or TFDs with different degrees of crystallinity. Those TFTs may have different degrees of crystallinity if some of those TFTs use a semiconductor layer that has been crystallized without adding a catalyst element thereto just like the TFD, for example.

This preferred embodiment is applicable effectively to an electronic device such as a liquid crystal display device with a sensor function or an organic EL display device. Specifically, if this preferred embodiment is applied to a display device with a sensor function, the following effects can be achieved.

In the field of liquid crystal display devices and organic EL display devices, by arranging a display area including a pixel section and a driver circuit on the same substrate, a display device of an even smaller size and with an even higher resolution is now being developed. And if logic circuits including a memory circuit and a clock generator are further integrated together on that substrate (to make a so-called "system on panel"), not just the size and weight of the display device but also the manufacturing cost thereof can be reduced as well. In addition, the reliability of the product can be increased, too. The pixel section of such a display device usually uses TFTs as its switching elements. And the driver circuit and the logic circuits thereof also use TFTs. Thus, to enhance the versatility of such a display device by adding totally different functions from those of a conventional display device to it, an electronic device such as a display device with a sensor function, in which a photosensor is provided inside and outside the display area by integrating TFTs and TFDs together on the same substrate and by using the device characteristic of the TFDs that cannot be achieved by the TFTs, has been proposed.

In any of those electronic devices, the photosensor unit may be an ambient sensor for adjusting the luminance of the display unit. Alternatively, the photosensor unit may also be a touchscreen panel sensor for the display unit. In either case, such an electronic device including a display unit and a photosensor unit will be an outstanding multipurpose product and can find a broad variety of applications.

To make such a display device with a sensor function, it is preferred that TFTs for use as switching elements in the pixel section, TFTs to form a driver circuit, and TFDs to form a photosensor be integrated together on the same substrate. If a crystalline semiconductor film is formed by crystallizing an amorphous semiconductor film by known crystal-growing process and then patterned into semiconductor layers for a TFT and a TFD, those components can be formed at the same time on the same substrate. According to every known crystal-growing process, however, the same crystalline semiconductor film is simply patterned into semiconductor layers for a TFT and a TFD, and can never be optimized separately to have those components satisfy performances required.

On the other hand, this preferred embodiment provides a display device that includes: a display area with a number of display units; and a frame area surrounding the display area. The display device further includes a photosensor unit including at least one thin-film diode. Each display unit includes an electrode and a thin-film transistor connected to the electrode. The thin-film transistor and the thin-film diode are arranged on the same substrate. The thin-film transistor includes: a semiconductor layer that has a channel region, a source region and a drain region; a gate electrode that controls the conductivity of the channel region; and a gate insulating film arranged between the semiconductor layer and the gate electrode. The thin-film diode includes a semiconductor layer with an n-type region, a p-type region and an intrinsic region interposed between the n- and p-type regions. The respective semiconductor layers of the thin-film transistor and the thin-film diode are portions of a single crystalline semiconductor layer obtained by crystallizing the same amorphous semiconductor film. At least the channel region of the semiconductor layer of the thin-film transistor has been crystallized by going through a heat treatment with a catalyst element, which promotes crystallization of the amorphous semiconductor film, added. The concentration of the catalyst element in the intrinsic region of the semiconductor layer of the thin-film diode is lower than that of the catalyst element in the channel region of the semiconductor layer of the thin-film transistor. Furthermore, it is preferred that the intrinsic region of the semiconductor layer of the thin-film diode include substantially no catalyst elements. Also, the intrinsic region of the semiconductor layer of the thin-film diode is preferably a crystalline semiconductor layer that has been crystallized by irradiating an amorphous semiconductor film with a laser beam. In this manner, a TFT's semiconductor layer that has been crystallized with a catalyst element and a TFD's semiconductor layer that includes a catalyst element in a lower concentration than the TFT's semiconductor layer can be formed on the same substrate. Thus, a pixel switching TFT with high field effect mobility and a photosensor TFD that exhibits a high bright current to dark current ratio with respect to external light can be formed on the same substrate at the same time. Consequently, a high-performance display device with a sensor function is realized to have a reduced size and yet maintain good display performance.

On top of that, according to this preferred embodiment, a crystalline semiconductor layer to be one of the two electrodes of a capacitor can be formed on the substrate out of the same amorphous semiconductor film as what has been turned into the respective semiconductor layers of the thin-film transistor and the thin-film diode. The concentration of the catalyst element in the semiconductor layer to be one of the two electrodes of a capacitor is lower than that of the catalyst element in the channel region of the semiconductor layer of the thin-film transistor. The electrode of the capacitor does not have to have a high degree of crystallinity but has only to function as an electrode. Rather microscopic surface unevenness such as etch pits might make the insulating film of the capacitor fail to cover such unevenness sufficiently, thus generating concern about leakage current that could flow through that insulating film. That is why if the capacitor is designed so as to either have a lower catalyst element concentration or include no catalyst elements at all, the harmful effects that could be produced by the catalyst element (e.g., the etch pits to be formed when a silicide compound is etched with HF) can be eliminated and the rate of failure of the capacitor (such as the leakage current to flow through the insulating film) can be reduced.

The semiconductor layer to be one of the two electrodes of the capacitor may be connected to the source or drain region of the semiconductor layer of the thin-film transistor. In that case, the pixel section can be laid out more efficiently and the aperture ratio can be increased.

This preferred embodiment also provides another display device that includes: a display area with a number of display units; and a frame area surrounding the display area. The display device further includes a photosensor unit including at least one thin-film diode. Each display unit includes an electrode and a first thin-film transistor connected to the electrode. A second thin-film transistor is provided in the frame area to form a driver circuit. The first and second thin-film transistors and the thin-film diode are arranged on the same substrate. Each of the first and second thin-film transistors includes: a semiconductor layer that has a channel region, a source region and a drain region; a gate electrode that controls the conductivity of the channel region; and a gate insulating film arranged between the semiconductor layer and the gate electrode. The thin-film diode includes a semiconductor layer with an n-type region, a p-type region and an intrinsic region interposed between the n- and p-type regions. The respective semiconductor layers of the first and second thin-film transistors and the thin-film diode are portions of a single crystalline semiconductor layer that has been obtained by crystallizing the same amorphous semiconductor film. At least the channel region of the respective semiconductor layers of the first and second thin-film transistors has been crystallized by going through a heat treatment with a catalyst element, which promotes crystallization of the amorphous semiconductor film, added. The concentration of the catalyst element in the intrinsic region of the semiconductor layer of the thin-film diode is lower than that of the catalyst element in the channel region of the respective semiconductor layers of the first and second thin-film transistors. Furthermore, it is preferred that the intrinsic region of the semiconductor layer of the thin-film diode include substantially no catalyst elements. Also, the intrinsic region of the semiconductor layer of the thin-film diode is preferably a crystalline semiconductor layer that has been crystallized by irradiating an amorphous semiconductor film with a laser beam. In this manner, TFTs' semiconductor layers that have been crystallized with a catalyst element and a TFD's semiconductor layer that includes a catalyst element in a lower concentration than the TFTs' semiconductor layers can be formed on the same substrate. Thus, a pixel switching TFT and a peripheral driver TFT with high field effect mobility and a photosensor TFD that exhibits a high bright current to dark current ratio with respect to external light can be formed on the same substrate at the same time. Consequently, a high-performance display device with a sensor function is realized to have a reduced size and yet maintain good display performance.

This preferred embodiment further provides still another display device that includes: a display area with a number of display units; and a frame area surrounding the display area. The display device further includes a photosensor unit including at least one thin-film diode. Each display unit includes an electrode and a first thin-film transistor connected to the electrode. A second thin-film transistor is provided in the frame area to form a driver circuit. The first and second thin-film transistors and the thin-film diode are arranged on the same substrate. Each of the first and second thin-film transistors includes: a semiconductor layer that has a channel region, a source region and a drain region; a gate electrode that controls the conductivity of the channel region; and a gate insulating film arranged between the semiconductor layer and the gate electrode. The thin-film diode includes a semiconductor layer with an n-type region, a p-type region and an intrinsic region interposed between the n- and p-type regions. The respective semiconductor layers of the first and second thin-film transistors and the thin-film diode are portions of a single crystalline semiconductor layer that has been obtained by crystallizing the same amorphous semiconductor film. At least the channel region of the semiconductor layer of the second thin-film transistor has been crystallized by going through a heat treatment with a catalyst element, which promotes crystallization of the amorphous semiconductor film, added. The concentrations of the catalyst element in the intrinsic region of the semiconductor layer of the thin-film diode and in the channel region of the semiconductor layer of the first thin-film transistor are lower than that of the catalyst element in the channel region of the semiconductor layer of the second thin-film transistor. Furthermore, it is preferred that the intrinsic region of the semiconductor layer of the thin-film diode and the channel region of the semiconductor layer of the first thin-film transistor include substantially no catalyst elements. Also, the intrinsic region of the semiconductor layer of the thin-film diode and the channel region of the semiconductor layer of the first thin-film transistor are preferably a crystalline semiconductor layer that has been crystallized by irradiating an amorphous semiconductor film with a laser beam. According to this preferred embodiment, not all of the TFTs, but only some TFTs (i.e., the second TFT), have their semiconductor layer formed by crystallizing a semiconductor film with a catalyst element, and the semiconductor layer of the other TFTs (i.e., the first TFT) and that of the TFD are formed on the same substrate out of a semiconductor film with a lower catalyst element concentration than the former TFTs. As a result, the peripheral driver TFT can achieve high field effect mobility, and the pixel switching TFT will allow minimum leakage current to flow due to the presence of the catalyst element while the TFT is in OFF state and will realize low OFF state current characteristic. In the photosensor unit, on the other hand, a photosensor TFD that exhibits a high bright current to dark current ratio with respect to external light can be formed on the same substrate at the same time. Consequently, a high-performance display device with a sensor function is realized to have a reduced size and yet maintain good display performance.

In this particular preferred embodiment, the driver to be formed by the second thin-film transistor in the frame area may be a driver to drive the first thin-film transistor that is connected to each display unit. Alternatively, the driver to be formed by the second thin-film transistor in the frame area may also be a driver to drive a photosensor unit including a thin-film diode. Still alternatively, both of these two types of drivers may be included as well.

In addition, according to this preferred embodiment, the semiconductor device further includes a capacitor, one of the two electrodes of which uses the crystalline semiconductor layer that has been turned into the respective semiconductor layers of the first and second thin-film transistors and the thin-film diode by crystallizing the same amorphous semiconductor film. The concentration of the catalyst element in the semiconductor layer to be one of the two electrodes of the capacitor is lower than that of the catalyst element in the channel region of the semiconductor layer of the second thin-film transistor. Furthermore, it is preferred that the semiconductor layer to be the one electrode of the capacitor include substantially no catalyst element. Also, the semiconductor layer to be the one electrode of the capacitor is preferably a crystalline semiconductor layer that has been obtained by crystallizing an amorphous semiconductor film with a laser beam. In this particular preferred embodiment, the semiconductor layer to be the one electrode of the capacitor is preferably connected to either the source region or the drain region of the semiconductor layer of the first thin-film transistor.

If the TFD is used as a photosensor in this manner, the semiconductor layer to be an active layer needs to react to only external light. On the other hand, a transmissive liquid crystal display device needs a backlight, and therefore, an opaque layer should be provided to face the backlight so that the light that has come from the backlight is not sensed. In general, the backlight is arranged on the back surface of an active-matrix substrate, and therefore, an opaque layer needs to be arranged under the semiconductor layer to be the active region of the TFD. For that reason, the thin-film diode of this preferred embodiment further includes an opaque layer, which is arranged on a light transmissive substrate and located between the semiconductor layer of the thin-film diode and that substrate. When viewed from under the back surface of the substrate, the opaque layer is preferably arranged so as to overlap with at least the intrinsic region of the semiconductor layer of the thin-film diode. In this case, since the opaque layer needs to cut off light, the opaque portion is preferably made of a metallic material. Among other things, a refractory metallic material is particularly preferred because such a metal can withstand the heat treatment to be performed later in the manufacturing process.

A method for fabricating a semiconductor device according to the present invention includes the steps of: providing a substrate, of which the surface is covered with an amorphous semiconductor film; selectively adding a catalyst element, which promotes crystallization, to only a part of the amorphous semiconductor film; heating the amorphous semiconductor film, to which the catalyst element has been added selectively, thereby crystallizing that catalyst-added part of the amorphous semiconductor film to define a catalyst-aided crystallized region and leaving the rest of the amorphous semiconductor film as an amorphous region; irradiating the catalyst-aided crystallized region and the amorphous region with a laser beam, thereby obtaining a crystalline semiconductor film that has a high crystallinity region, which has been defined by either further crystallizing or re-crystallizing the catalyst-aided crystallized region, and a low crystallinity region, which has been defined by crystallizing the amorphous region; and patterning the high crystallinity region of the crystalline semiconductor film into at least a part of a first semiconductor island to define an active region for the thin-film transistor and the low crystallinity region of the crystalline semiconductor film into at least a part of a second semiconductor island to define an active region for the thin-film diode.

According to this manufacturing method, a portion to be the channel region of a thin-film transistor is preferably defined out of the high crystallinity region of the crystalline semiconductor film. Also, a portion to be the intrinsic region of a thin-film diode is preferably defined out of the low crystallinity region of the crystalline semiconductor film. Alternatively, the first semiconductor island in its entirety may be defined out of the high crystallinity region of the crystalline semiconductor film. Or the second semiconductor island in its entirety may be defined out of the low crystallinity region of the crystalline semiconductor film.

As used herein, the "high crystallinity region" refers to a region with a high degree of crystallinity, which has been crystallized with a catalyst element and then either further crystallized or re-crystallized with a laser beam. The high crystallinity region is preferably made of continuous grain silicon. In the high crystallinity region, the crystals grow laterally (i.e., parallel to the surface of the substrate) and each crystal domain has a relatively large size of 2 µm to 8 µm and has a peculiar crystallographic plane orientation as described above. On the other hand, the "low crystallinity region" has been crystallized without using any catalyst element and is made of polysilicon just like normal low temperature polysilicon. In the low crystallinity region, the crystals grow vertically upward from the substrate (i.e., perpendicularly to the substrate) and each crystal grain has a relatively small size of 50 nm to 500 nm.

Another method for fabricating a semiconductor device according to the present invention includes the steps of: providing a substrate, of which the surface is covered with an amorphous semiconductor film; selectively adding a catalyst element, which promotes crystallization, to only a part of the amorphous semiconductor film; heating the amorphous semiconductor film, to which the catalyst element has been added selectively, thereby crystallizing that catalyst-added part of the amorphous semiconductor film to define a first catalyst-aided crystallized region, growing crystals laterally (parallel to the substrate) from the first catalyst-aided crystallized region, thereby defining a second catalyst-aided crystallized region, and leaving the rest of the amorphous semiconductor film, to which no catalyst element has been added and which has not been reached by any crystallized region, as an amorphous region; irradiating the first and second catalyst-aided crystallized regions and the amorphous region with a laser beam, thereby obtaining a crystalline semiconductor film including a first high crystallinity region, which has been defined by either further crystallizing or re-crystallizing the first catalyst-aided crystallized region, a second high crystallinity region, which has been defined by either further crystallizing or re-crystallizing the second catalyst-aided crystallized region, and a low crystallinity region, which has been defined by crystallizing the amorphous region; and patterning the second high crystallinity region of the crystalline semiconductor film into at least a part of a first semiconductor island to define an active region for the thin-film transistor and the low crystallinity region of the crystalline semiconductor film into at least a part of a second semiconductor island to define an active region for the thin-film diode.

In this manufacturing process, a portion to be the channel region of a thin-film transistor is preferably defined out of the second high crystallinity region of the crystalline semiconductor film. Also, a portion to be the intrinsic region of a thin-film diode is preferably defined out of the low crystallinity region of the crystalline semiconductor film. Alternatively, the first semiconductor island in its entirety may be defined out of the second high crystallinity region of the crystalline semiconductor film. Or the second semiconductor island in its entirety may be defined out of the low crystallinity region of the crystalline semiconductor film.

Optionally, a portion to be the source region and/or the drain region of a thin-film transistor may also be defined out of the first high crystallinity region of the crystalline semiconductor film. Then, even a region to which a catalyst element has been introduced selectively can also be used as a part of the device. As a result, the devices can be laid out more flexibly and can be integrated together in greater numbers.

According to any of these manufacturing methods, the respective semiconductor layers of the TFT and the TFD, and eventually the channel region of the TFT and the intrinsic region of the TFD, can be defined in their best shapes and conditions independently of each other. As a result, the TFT has a field effect mobility that is high enough to achieve high drivability and excellent switching characteristic. On the other hand, the TFT has so little dark current as to achieve a high bright current to dark current ratio (or SNR) for a photosensor. As a result, by using a semiconductor layer that has been obtained by crystallizing the same amorphous semiconductor film, the TFT and the TFD can achieve their best device performances at the same time. On top of that, the semiconductor device of the present invention can be fabricated at a lower manufacturing cost without increasing the number of manufacturing processing steps to form these two types of semiconductor components on the same substrate.

Also, in any of these manufacturing methods, a semiconductor layer to be one of the two electrodes of a capacitor may be formed out of the high crystallinity region of the crystalline semiconductor film (or the second high crystallinity region if the high crystallinity region includes first and second high crystallinity regions). In that case, it is possible to prevent the upper insulating film from covering the underlying layer imperfectly due to an etch pit that could be caused by the deposition of the catalyst element and also prevent the breakdown voltage from being decreased due to the diffusion of the catalyst element into the insulating film. As a result, a highly reliable capacitor with a high breakdown voltage can be obtained.

Optionally, the semiconductor device of the preferred embodiment described above may further include another thin-film transistor, which will be referred to herein as a "second thin-film transistor". In that case, a semiconductor island to be the active region of the second thin-film transistor may be defined out of the low crystallinity region of the crystalline semiconductor film. That is to say, if some thin-film transistors do not use the catalyst element but use the same crystalline semiconductor as the semiconductor layer of the TFD, the amount of leakage current to flow in the OFF state can be further reduced. Nevertheless, the ON-state performance of the thin-film transistor will deteriorate then. That is why, in that case, one of the two types of thin-film transistors needs to be used selectively according to the specifications of the display device to which the semiconductor device of the present invention is applied.

Also, in any of these manufacturing methods, the step of crystallizing at least a portion of an amorphous semiconductor film by adding a catalyst element, which promotes its crystallization, and then heating it preferably includes: covering the amorphous semiconductor film with a mask that has an opening; and adding the catalyst element to a selected region of the amorphous semiconductor film through the opening. By selectively doping the amorphous semiconductor film with the catalyst element and then heating it in this manner so that crystals grow laterally from that region to which the catalyst element has been added selectively to its surrounding regions to form a crystalline semiconductor film, a quality crystalline semiconductor film, in which crystals have grown in almost the same direction, can be obtained and the current drivability of the TFT can be further increased. On top of that, in that region in which the crystals have grown laterally (i.e., the second catalyst-aided crystallized region), the in-film concentration of the catalyst element after the crystal growth can be lower by one digit or two than in the region to which the catalyst element has been added directly (i.e., the first catalyst-aided crystallized region). As a result, the load on the subsequent processing steps and the influence on the device can be both reduced.

Furthermore, the step of radiating the laser beam preferably includes irradiating the catalyst-aided crystallized region and the amorphous region with a laser beam having such an energy density that is not so high as to totally reset the degree of crystallinity of the catalyst-aided crystallized region yet to be irradiated with the laser beam but is high enough to crystallize the amorphous region. If the energy density falls within such a range, the respective semiconductor layers of the TFT and the TFD, and eventually the channel region of the TFT and the intrinsic region of the TFD, can be defined in their best shapes and conditions independently of each other. As a result, the TFT has a field effect mobility that is high enough to achieve high drivability and excellent switching characteristic. On the other hand, the TFT has so little dark current as to achieve a high bright current to dark current ratio (or SNR) for a photosensor.

Also, in any of these manufacturing methods, the substrate may transmit light, and the method may further include the step of forming an opaque layer for cutting off light that has come through the back surface of the substrate under a region of the substrate in which the semiconductor island to be the active region of a thin-film diode will be formed. In that case, in a liquid crystal display device, for example, the backlight that has come from under the back surface of the substrate can be cut off effectively, and only the light that has come from over the TFD can be sensed just as intended.

Furthermore, in the manufacturing process of the present invention, after the first semiconductor layer to be the active region of a thin-film transistor and the second semiconductor layer to be the active region of a thin-film diode have been defined as described above, the method may further include the steps of: forming a gate insulating film that covers at least the first semiconductor island; forming a gate electrode on the gate insulating film that covers the first semiconductor island; doping portions of the first semiconductor island, which will be source and drain regions, with a dopant element; doping a portion of the second semiconductor island, which will be an n-type region, with an n-type dopant element; and doping another portion of the second semiconductor island, which will be a p-type region, with a p-type dopant element.

In this manner, n-type or p-type doped regions to be source/drain regions are defined in the semiconductor layer of the TFT, and an n-type doped region and a p-type doped region are defined in the semiconductor layer of the TFD, thereby completing these devices on the same substrate. In this case, in step of doping portions of the first semiconductor island to be source/drain regions with a dopant element, that dopant element to be added to those portions of the first semiconductor island to be the source/drain regions is preferably an n-type dopant element and that process step is preferably carried out simultaneously with the process step of doping a portion of the second semiconductor island to be an n-type region with an n-type dopant element. That is to say, the doping process step to define the source/drain regions of an n-channel TFT and the doping process step to define the n-type doped region of a TFD can be performed as the same process step in that case. As a result, the manufacturing process can be simplified.

Alternatively, in step of doping portions of the first semiconductor island to be source/drain regions with a dopant element, that dopant element to be added to those portions of the first semiconductor island to be the source/drain regions may be a p-type dopant element and that process step may be carried out simultaneously with the process step of doping a portion of the second semiconductor island to be a p-type region with a p-type dopant element. That is to say, the doping process step to define the source/drain regions of a p-channel TFT and the doping process step to define the p-type doped region of a TFD can be performed as the same process step in that case. As a result, the manufacturing process can be simplified.

Still alternatively, the first semiconductor island may be a first group of at least two semiconductor islands to be the respective active regions of n-channel and p-channel thin-film transistors. In that case, the process step of doping those portions of the first group of semiconductor islands to be the source/drain regions with a dopant element may include doping a semiconductor island of the first group to form part of an n-channel thin-film transistor with an n-type dopant element and doping another semiconductor island of the first group to form part of a p-channel thin-film transistor with a p-type dopant element. In that case, the process step of doping portions of the semiconductor island of the first group to be the source/drain regions of an n-channel thin-film transistor with an n-type dopant element is preferably carried out simultaneously with the process step of doping a portion of the second semiconductor island to be an n-type region with an n-type dopant element. On the other hand, the process step of doping portions of the semiconductor island of the first group to be the source/drain regions of a p-channel thin-film transistor with a p-type dopant element is preferably carried out simultaneously with the process step of doping a portion of the second semiconductor island to be an n-type region with a p-type dopant element.

In that case, if a TFT circuit with a CMOS configuration is going to be fabricated, the doping process step to define the source/drain regions of its n-channel TFT and the doping process step to define the n-type doped region of its TFD can be carried out as the same process step. In addition, the doping process step to define the source/drain regions of its p-channel TFT and the doping process step to define the p-type doped region of its TFD can be carried out as a single process step as well. As a result, the manufacturing process can be simplified significantly. Consequently, a semiconductor device including a TFT and TFD on the same substrate, each of which has a crystalline semiconductor film with the best degree of crystallinity for that semiconductor component and which exhibits good performance as well, can be provided at a lower manufacturing cost without increasing the number of the manufacturing processing steps required.

Also, in any of these manufacturing methods, the process step of doping a portion of the second semiconductor island to be an n-type region with an n-type dopant element and the process step of doping another portion of the second semiconductor island to be a p-type region with a p-type dopant element are preferably carried out so that a non-doped region (i.e., an intrinsic region) is defined between those portions of the second semiconductor island to be n-type and p-type regions as a result of the two doping process steps.

### (EMBODIMENT 1)

Hereinafter, a semiconductor device as a first preferred embodiment of the present invention will be described. The semiconductor device of this preferred embodiment includes an n-channel TFT and a TFD on the same substrate and may be used as an active-matrix-addressed display device with a sensor section, for example.

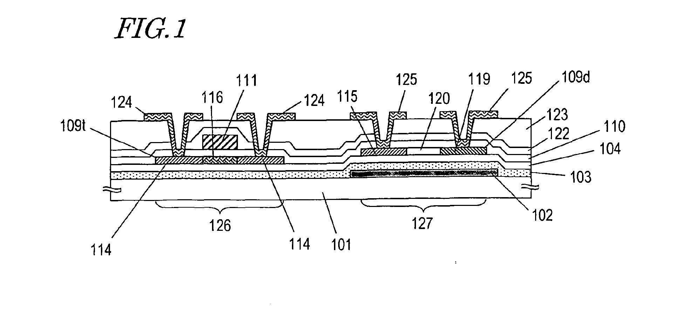

FIG. **1** is a schematic cross-sectional view illustrating an exemplary semiconductor device according to this preferred embodiment. The semiconductor device of this preferred embodiment typically includes a number of TFTs and a number of TFDs on the same substrate. In FIG. **1****,** however, the configurations of just one of those TFTs and only one of those TFDs are illustrated.

The semiconductor device of this preferred embodiment includes a thin-film transistor **126** and a thin-film diode **127,** which are arranged on a substrate **101** with undercoat films **103** and **104** interposed between them. The thin-film transistor **126** includes a semiconductor layer **109t** with a channel region **116** and source/drain regions **114,** a gate insulating film **110** on the semiconductor layer **109t,** a gate electrode **111** that controls the conductivity of the channel region **116,** and electrodes and interconnects **124** that are connected to the source/drain regions **114.** On the other hand, the thin-film diode **127** includes a semiconductor layer **109d** with at least an n-type region **115** and a p-type region **119** and electrodes and interconnects **125** that are connected to the n- and p-type regions **115** and **119.** In the example illustrated in FIG. **1****,** an intrinsic region **120** is arranged between the n- and p-type regions **115** and **119** of the semiconductor layer **109d.**

The thin-film transistor **126** and the thin-film diode **127** are coated with a silicon nitride film **122** and a silicon dioxide film **123** as interlevel dielectric films. Also arranged between the semiconductor layer **109d** of the thin-film diode **127** and the substrate **101** is an opaque layer 102.

The respective semiconductor layers **109t** and **109d** of the thin-film transistor **126** and the thin-film diode **127** are portions of a crystalline semiconductor layer obtained by crystallizing the same amorphous semiconductor film, and have been crystallized by two different methods and include the catalyst element in mutually different concentrations. Specifically, the semiconductor layer **109d** of the thin-film diode **127** includes the catalyst element in a lower concentration than the semiconductor layer **109t** of the thin-film transistor **126.**

For example, the n-channel thin-film transistor **126** and the thin-film diode **127** shown in FIG. **1** may be fabricated in the following procedure.

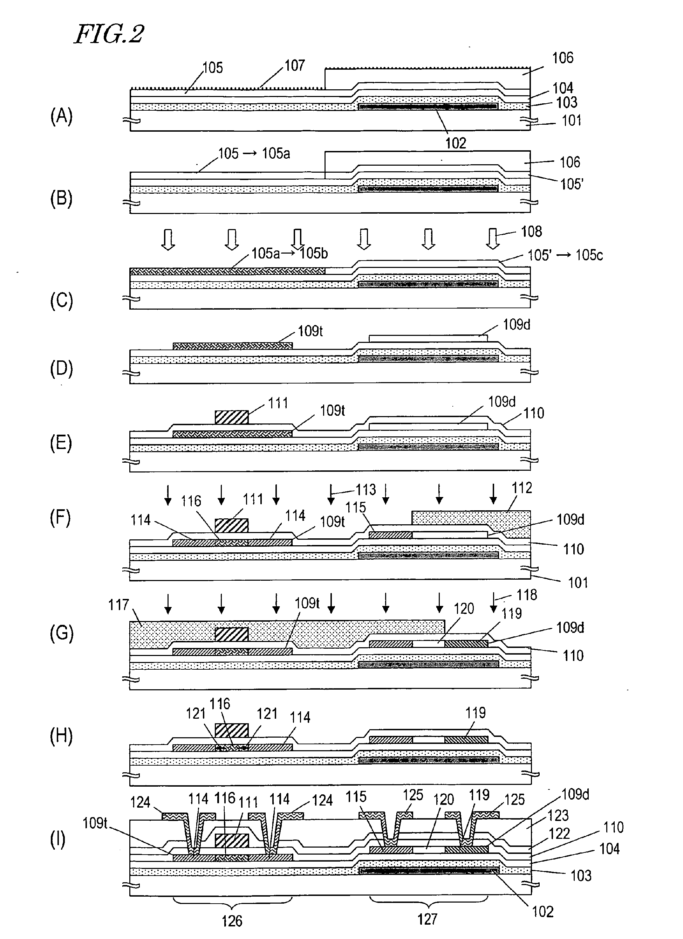

FIGS. **2 (A)** through **2(I)** are cross-sectional views illustrating the respective process steps to fabricate the thin-film transistor **126** and the thin-film diode **127** of this preferred embodiment. These process steps are carried out in the same order that these portions (A) through (I) of FIG. **2** are arranged.

First, as shown in FIG. **2(A)****,** an opaque layer **102,** undercoat films **103** and **104,** an amorphous semiconductor film **105** and a mask film **106** are formed on the substrate **101** and a catalyst element **107** is added.

A low alkali glass substrate or a quartz substrate may be used as the substrate **101.** In this preferred embodiment, a low alkali glass substrate is used. In that case, the glass substrate may be heat-treated in advance to a temperature that is lower than the glass stain point by about 10-20 °C.

On the surface of that substrate **101** on which a TFT and a TFD will be fabricated, the opaque layer **102** is formed. In the final product, the opaque layer **102** functions to shield the TFD from the light that has come from under the back surface of the substrate. The opaque layer **102** may be made of a metal film or a silicon film, for example. If a metal film is used, a refractory metal such as tantalum (Ta), tungsten (W) or molybdenum (Mo) is preferably used considering the heat treatment to be carried out at a later stage of the manufacturing process.

In this preferred embodiment, a Mo film is deposited by sputtering process and then patterned, thereby forming the opaque layer 102 shown in FIG. **2(A)****.** In this case, the opaque layer 102 may have a thickness of 30 nm to 200 nm and preferably has a thickness of 50 nm to 150 nm (e.g., 100 nm in this preferred embodiment).

Next, as shown in FIG. **2(A)****,** undercoat films **103** and **104** of silicon dioxide, silicon nitride or silicon oxynitride, for example, are deposited to prevent impurities from diffusing from the substrate **101.** In this preferred embodiment, a silicon oxynitride film is deposited as the lower, first undercoat film **103** by performing a plasma CVD process with source gases of SiH₄, NH₃ and N₂O supplied, and then a second undercoat film **104** is deposited thereon by performing a plasma CVD process again with source gases of SiH₄ and N₂O supplied. In this case, the first undercoat film **103** of-silicon oxynitride preferably has a thickness of 30 nm to 400 nm (e.g., 200 nm) and the second undercoat film **104** of silicon dioxide preferably has a thickness of 50 nm to 200 nm (e.g., 100 nm). Although a two-layered undercoat film **103, 104** is supposed to be used in this preferred embodiment, a single layer of silicon dioxide may also be used.

Next, a silicon film 105 with an amorphous structure (i.e., an amorphous silicon film) is deposited as an amorphous semiconductor film to a thickness of 20 nm to 150 nm (preferably in the range of 30 nm to 80 nm) by a known process such as a plasma CVD process or a sputtering process. In this preferred embodiment, an amorphous silicon film is deposited to a thickness of 50 nm by plasma CVD process. Optionally, the undercoat films **103** and **104** and the amorphous silicon film 105 may be deposited continuously because these films can be formed by the same deposition process. If the substrate on which the undercoat films **103** and **104** have been deposited is not exposed to the air, contamination on its surface can be avoided and variations in characteristic or threshold voltage between the TFTs to fabricate can be minimized.

Subsequently, either a silicon dioxide film or a silicon nitride film is deposited to a thickness of 50 nm to 400 nm (e.g., 200 nm) and then patterned to have an opening, thereby forming a masking film **106** as shown in FIG. **2(A)****.** As a result of this process step, a portion of the amorphous silicon film **105,** on which a TFT will be fabricated, is exposed through the opening of the masking film **106.**

Thereafter, the surface of the amorphous silicon film is coated with an aqueous solution including approximately 1-10 ppm (e.g., 5 ppm) by weight of catalyst element **107** (e.g., nickel in this preferred embodiment) such as an aqueous solution of nickel acetate by spin coating process, thereby forming a catalyst element containing layer. The catalyst element **107** selectively contacts with the amorphous silicon film **105** inside the opening of the masking film **106,** thereby defining a catalyst element added region. This is the state shown in FIG. **2(A)****.** The catalyst element(s) **107** is/are preferably one or multiple elements selected from the group consisting of iron (Fe), cobalt (Co), tin (Sn), lead (Pb), palladium (Pd) and copper (Cu) as well as nickel (Ni). Although their catalyst effects are lower than those of the former elements, ruthenium (Ru), rhodium (Rh), osmium (Os), iridium (Ir), platinum (Pt) or gold (Au) may also serve as a catalyst element. The dose of the catalyst element to be added in this process step is very small. And the concentration of the catalyst element at the surface of the amorphous silicon film **105** and the masking film **106** is controlled by total reflection X-ray fluorescence (TRXRF) analysis. In this preferred embodiment, the catalyst element has a concentration of approximately 5 × 10¹² atoms/cm². Optionally, before this process step is performed, the surface of the amorphous silicon film **105** may be slightly oxidized with ozone water, for example, to increase the wettability at the surface of the amorphous silicon film **105** during the spin-coating process.

In this preferred embodiment, nickel is supposed to be introduced by spin coating process. However, a thin film of a catalyst element (e.g., a nickel film in this preferred embodiment) may be formed on the amorphous silicon film 105 by an evaporation process or a sputtering process, for example.

Subsequently, as shown in FIG. **2(B)****,** a part of the amorphous silicon film **105** is crystallized. In this preferred embodiment, the substrate is thermally treated within an inert atmosphere (e.g., a nitrogen gas ambient). As this heat treatment process, annealing is preferably carried out at a temperature of 500 °C to 650 °C for any required length of time between 30 minutes and 4 hours. In this preferred embodiment, the heat treatment is conducted at 600 °C for an hour. As a result of this heat treatment, the nickel atoms that have been added as the catalyst element **107** to the surface of the amorphous silicon film **105** diffuse through the amorphous silicon film **105** and also produce silicides, thereby crystallizing the amorphous silicon film **105** using those silicides as nuclei of crystal growth. Consequently, the amorphous silicon film **105** gets crystallized in that region to be a crystalline silicon region **105a** (which will also be referred to herein as a "catalyst-aided crystallized region"). In this process step, the nickel atoms **106** on the masking film **106** are prevented by the masking film **106** from reaching the underlying amorphous silicon film. As a result, the region masked with the masking film **106** remains amorphous (i.e., to be an amorphous silicon region **105').** Although the crystallization process is produced in this preferred embodiment by heat treatment process using a furnace, the crystallization may also be produced with a rapid thermal annealing (RTA) system that uses a lamp as a heat source.

Thereafter, the masking film **106** is stripped and then the silicon film, including both the crystalline silicon region **105a** and amorphous silicon region **105',** is irradiated with a laser beam **108** as shown in FIG. **2(C)****.** As a result, the crystalline silicon region **105a,** which has been selectively crystallized with the catalyst element introduced, has had its crystal imperfections reduced by going through this melting and solidification process, including irradiation with the laser beam **108,** and has been re-crystallized using its parts as nuclei of crystal growth to be a crystalline silicon region **105b** of even higher quality (which will be referred to herein as a "high crystallinity region"). On the other hand, the amorphous region also gets crystallized by going through the melting and solidification process, including irradiation with the laser beam **108,** to be a crystalline silicon region 105c (which will be referred to herein as a "low crystallinity region").

In this process step, an XeCl excimer laser beam (with a wavelength of 308 nm) or a KrF excimer laser beam (with a wavelength of 248 nm) may be used as the laser beam. Also, in this process step, the sizes of the laser beam spot are determined so that an elongated beam spot is formed on the surface of the substrate **101.** And by sequentially scanning the surface of the substrate **101** perpendicularly to the direction in which the beam spot is elongated, the crystalline silicon film gets re-crystallized over the entire surface of the substrate. In this case, if the surface is scanned so that the beam spots partially overlap with each other, an arbitrary point on the crystalline silicon region **105a** and the amorphous region **105** will be irradiated with the laser beam multiple times, thus contributing to increasing the uniformity. In this preferred embodiment, the sizes of the beam spot are determined so that the beam spot has an elongated shape of 300 mm × 0.4 mm on the surface of the substrate **101** and the substrate is sequentially scanned at a step of 0.02 mm perpendicularly to the direction in which the beam spot is elongated. That is to say, any arbitrary point on the silicon film gets irradiated with the laser beam 20 times in total. Examples of laser beams that can be used in this process step include KrF and XeCl excimer laser beams of pulsed or continuous wave type described above but also a YAG laser beam or a YVO4 laser beam as well. Also, in this process step, the silicon film may be irradiated with the laser beam with an energy density of 250 to 450 mJ/cm², e.g., 350 mJ/cm². In this case, if the energy density of the laser beam were too high, the degree of crystallinity of the crystalline silicon region **105a** that has been obtained in the previous process step would be reset.

In this case, the crystallographic plane orientations of the crystalline silicon region **105b** thus obtained have already been almost determined in the solid-phase crystallization process step using the catalyst element. Specifically, the majority of the crystalline silicon region **105b** is comprised of a <111> zone. Among other things, (110) and (211) planes account for 50% or more of all crystal planes. And the crystalline silicon region **105b** has an average crystal grain size (corresponding to the domain size of a crystal domain (i.e., a region with substantially the same plane orientation)) of 2 µm to 5 µm. On the other hand, the crystalline silicon region **105c** that has been crystallized from the amorphous state by being irradiated with the laser beam has random crystallographic plane orientations, which include a lot of (100) planes and (111) planes, among other things. Those (100) and (111) planes do not fall into the <111> zone. And the crystalline silicon region 105c has an average crystal grain size of 100 nm to 300 nm.

Thereafter, as shown in FIG. **2(D)****,** excessive portions of the crystalline silicon regions **105b** and **105c** are removed, thereby electrically isolating two element regions from each other. In this process step, the crystalline silicon region **105b** that has been crystallized with nickel is patterned into a semiconductor island **109t** to be the active region (including source/drain regions and a channel region) of a TFT and the region 105c that has been crystallized only by being irradiated with the laser beam without nickel added is patterned into a semiconductor island **109d** to be the active region (including n⁺ and p⁺ regions and an intrinsic region) of a TFD.

Subsequently, as shown in FIG. **2(E)****,** a gate insulating film **110** is deposited over these semiconductor islands **109t** and **109d.** The gate insulating film 110 is preferably a silicon dioxide film with a thickness of 20 nm to 150 nm. In this preferred embodiment, a silicon dioxide film with a thickness of 100 nm was used.

Next, a conductive film is deposited on the gate insulating film **110** by sputtering process or CVD process, for example, and then patterned into the shape of a gate electrode **111** for a TFT. In this process step, the conductive film is not deposited on the semiconductor island **109d** to form part of a TFD. The conductive film to deposit in this process step is preferably a refractory metal such as W, Ta, Ti or Mo or an alloy thereof, and preferably has a thickness of 300 nm to 600 nm. In this preferred embodiment, tantalum (Ta) with a very small amount of additive nitrogen was deposited to a thickness of 450 nm.

Thereafter, as shown in FIG. **2(F)****,** a photoresist mask **112** is formed on the gate insulating film 110 so as to partially cover the semiconductor island **109d** to be the active region of a TFD, and ions **113** of an n-type dopant (such as phosphorus) are implanted into the entire surface of the substrate **101** from over it. The conditions of this ion implantation process step are determined so that the phosphorus ions **113** pass through the gate insulating film **110** and are implanted into the semiconductor layers **109t** and **109d.** As a result of this process step, the phosphorus ions **113** are implanted into a portion of the semiconductor island **109d** to be the active region of a TFD, which is not covered with the photoresist mask **112,** and into portions of the semiconductor island **109t** to be the active region of a TFT, which are not covered with the gate electrode-to-be **111.** That is to say, no phosphorus ions **113** are introduced into the regions covered with the photoresist mask **112** and the gate electrode-to-be **111.** Consequently, those portions of the semiconductor layer **109t** to form part of a TFT, implanted with the phosphorus ions **113,** will be the source/drain regions **114** of the TFT, while the portion masked with the gate electrode-to-be **111** and implanted with no phosphorus ions **113** will be the channel region **116** of the TFT. On the other hand, the portion of the semiconductor island **109d** to form part of a TFD, implanted with the phosphorus ions **113,** will be the n⁺ region **115** of the TFD.

Next, the photoresist mask **112** used in the previous process step is stripped and then another photoresist mask **117** is formed on the gate insulating film **108** so as to cover a part of the semiconductor island **109d** to be the active region of a TFD and entire semiconductor island **109t** to be the active region of a TFT, and ions **118** of a p-type dopant (such as boron) are implanted into the entire surface of the substrate **101** from over it as shown in FIG. **2(G)****.** The conditions of this ion implantation process step are determined so that the boron ions **118** are passed through the gate insulating film **110** and implanted into the semiconductor island **109d.** As a result of this process step, the boron ions **118** are implanted into a portion of the semiconductor island **109d** to form part of a TFD, which is not covered with the photoresist mask **117.** That is to say, no boron ions **118** are introduced into the regions covered with the photoresist mask **117.** Consequently, that portion of the semiconductor island **109d** to form part of a TFD, implanted with the boron ions **118,** will be the p⁺ region **119** of the TFD, while the portion implanted with no phosphorus ions in the previous process step, either, will be the intrinsic region **120** thereof.

Subsequently, the photoresist mask **118** is stripped and then the substrate is thermally treated within an inert atmosphere (e.g., a nitrogen gas ambient). As a result of this heat treatment process, various doping damages such as crystal imperfections that have been caused during the ion implantation process steps in the portions to be the source/drain regions **114** of a TFT and in the portions to be the n⁺ and p⁺ regions **115** and **119** of a TFD are repaired and the phosphorus and boron dopant atoms introduced there are activated as shown in FIG. **2(H)****.** Consequently, the source/drain regions **114** of the TFT and the n⁺ and p⁺ regions **115** and **119** of the TFD can have their resistance reduced. As a result of this heat treatment process, the phosphorus atoms that have been introduced into the portions of the semiconductor layers to be the source/drain regions **114** of a TFT will increase the concentration of nickel solid solution in those regions, thereby moving the nickel atoms from the channel region **116** to the source/drain regions in the directions indicated by the arrows **221.** Since the nickel atoms have come into the source/drain regions **114** to form parts of the TFT as a result of the heat treatment process, the concentrations of nickel in those regions has become higher than in the channel region **116** and is now equal to or higher than 1 × 10¹⁸/cm³. The heat treatment process of this process step may be carried out with a normal heating furnace but is preferably performed as a rapid thermal annealing (RTA). Among other things, it is particularly preferred that the temperature of the substrate be raised or lowered instantaneously by spraying a high-temperature inert gas against the surface of the substrate.

Thereafter, as shown in FIG. **2(I)****,** a silicon dioxide film and/or a silicon nitride film is/are deposited as an interlevel dielectric film. In this preferred embodiment, the interlevel dielectric film has a dual layer structure consisting of a silicon nitride film **122** and a silicon dioxide film **123.** After that, contact holes are cut through the interlevel dielectric film and a metallic material is deposited thereon and patterned into electrodes and interconnects **124** and **125** to form parts of a TFT and a TFD.

Finally, this structure is annealed at a temperature of 350°C to 450 °C within either a nitrogen gas ambient or a hydrogen gas mixed ambient at the atmospheric pressure, thereby completing a thin-film transistor **126** and a thin-film diode **127** as shown in FIG. **2(I)****.** Optionally, to protect these devices, a passivation film of silicon nitride, for example, may be deposited over the thin-film transistor **126** and the thin-film diode **127.**

In this manner, the respective semiconductor layers of a TFT and a TFD and the channel region of the TFT and the intrinsic region of the TFD can be defined in their best shapes and conditions independently of each other. As a result, by using the semiconductor layer obtained by crystallizing the same amorphous semiconductor film, a TFT and a TFD can have their best device characteristics at the same time. In this preferred embodiment, the semiconductor layer of the TFD has a substantially zero nickel concentration, which is not observed by any measuring means. On the other hand, in the semiconductor layer of the TFT, the catalyst element has gathered to its source/drain regions **114** where the catalyst element has a concentration of 1 × 10¹⁸/cm³ or more. In the channel region **116,** the catalyst element has a concentration of approximately 1 × 10¹⁵/cm³ to 1 × 10¹⁶/cm³ as described above.

### (EMBODIMENT 2)

Hereinafter, a method for fabricating a semiconductor device as a second specific preferred embodiment of the present invention will be described. In this preferred embodiment, the semiconductor layer of a TFT and that of a TFD are formed on a glass substrate independently of each other by a different method from the one used in the first preferred embodiment described above.

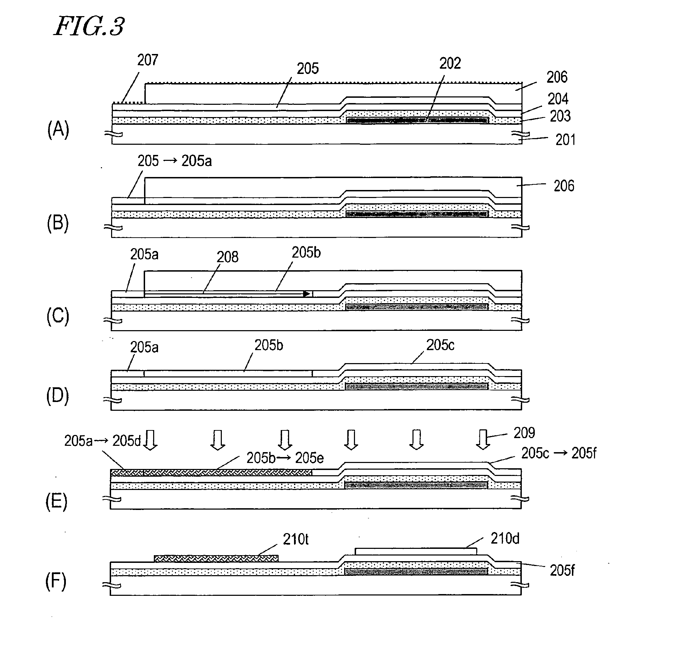

FIGS. **3(A)** through **3(F)** are cross-sectional views illustrating the respective process steps to make respective semiconductor layers **210t** and **210d** for a thin-film transistor and a thin-film diode according to this preferred embodiment. These process steps are carried out in the same order that these portions (A) through (F) of FIG. **3** are arranged.

First, an opaque layer **202** of Mo, for example, is formed on a substrate **201** (which may be a glass substrate according to this preferred embodiment) by the same method as the one adopted in the first preferred embodiment of the present invention described above. Subsequently, a silicon nitride film is deposited as the lower, first undercoat film 203, and then a second undercoat film **204** of silicon dioxide is deposited thereon so as to prevent impurities from diffusing from the substrate. Next, an amorphous silicon film **205** is deposited to a thickness of 30-80 nm (e.g., 50 nm). In this process step, the undercoat insulating films and the amorphous semiconductor film may be deposited continuously without exposing them to the air.

Next, a masking film **206** of silicon dioxide is deposited to a thickness of approximately 200 nm. The masking insulating film has an opening, through which a catalyst element is added to the semiconductor film as shown in FIG. **3(A)****.**

Thereafter, the surface of the substrate is coated with an aqueous solution including approximately 30 ppm by weight of catalyst element (e.g., nickel in this preferred embodiment) such as an aqueous solution of nickel acetate by spin coating process, thereby forming a catalyst element containing layer. Then, the catalyst element **207** in the catalyst element containing layer locally contacts with the amorphous silicon film 205 inside the opening of the masking film **206,** thereby defining a catalyst element added region there. This is the state illustrated in FIG. **3(A)****.**

In this preferred embodiment, nickel 207 is supposed to be introduced by spin coating process. However, a thin film of a catalyst element (e.g., a nickel film in this preferred embodiment) may be formed on the amorphous silicon film by evaporation process or sputtering process, for example.

Subsequently, the substrate is thermally treated at a temperature of 500 °C to 650 °C (preferably in the range of 550 °C to 620 °C) for any required length of time between 1 to 10 hours. In this preferred embodiment, the substrate is heat-treated at 600 °C for two hours. As a result, as shown in FIG. **3(B)****,** crystal nuclei are generated in the catalyst element added region, thereby crystallizing that portion of the amorphous silicon film **205** first into a crystalline silicon region **205a** (which will also be referred to herein as a "first catalyst-aided crystallized region"). After that, the crystallization further progresses substantially parallel to the substrate **201** (i.e., in the direction indicated by the arrow **208**) from the crystalline silicon region **205a** that has already been crystallized, thereby defining a crystalline silicon region **205b** (which will also be referred to herein as a "second catalyst-aided crystallized region" and) of which the crystal growing directions are substantially uniform macroscopically, as shown in FIG. **3(C)****.** Meanwhile, the nickel atoms on the masking film **206** are prevented by the masking film **206** from reaching the underlying amorphous silicon film. Therefore, the amorphous silicon film **205** gets crystallized only by the nickel atoms introduced through the opening. Also, the region in which the lateral crystal growth has never occurred remains amorphous silicon region **205c.** After that, the masking film (of silicon dioxide) **206** is removed to realize the state shown in FIG. **3(D)****.**

Next, the silicon film, including both the crystalline silicon regions **205a** and **205b** and the amorphous silicon region **205c,** is irradiated with a laser beam **209** as shown in FIG. **3(E)****.** In this process step, an XeCl excimer laser beam (with a wavelength of 308 nm) may be used as the laser beam as in the first preferred embodiment described above. And the surface is scanned so that the beam spots partially overlap with each other and that an arbitrary point on the silicon film will be irradiated with the laser beam multiple times, thus contributing to increasing the uniformity.

The crystalline silicon regions **205a** and **205b** that have been selectively crystallized with the addition of the catalyst element have had their crystal imperfections reduced by going through a melting and solidification process caused by the irradiation with the laser beam **209** and also re-crystallize using some of them as nuclei of crystal growth. As a result, the crystalline silicon regions **205a** and **205b** turn into crystalline silicon regions **205d** and **205e** with an even higher degree of crystallinity. Among other things, the crystalline silicon region **205e** (which will be referred to herein as a "second high crystallinity region" and), in which the lateral crystal growth has occurred, has come to have a higher degree of crystallinity than the crystalline silicon region **205d** (which will be referred to herein as a "first high crystallinity region") to be a crystalline silicon film with even higher crystallinity.

Meanwhile, the amorphous silicon region **205c** is crystallized by going through the melting and solidification process caused by the irradiation with the laser beam **209** to turn into a crystalline silicon region **205f** (which will be referred to herein as a "low crystallinity region"). In this process step, the laser beam was radiated at an energy density of 250 mJ/cm² to 450 mJ/cm² (e.g., 350 mJ/cm²). In this case, the energy density of the laser beam should not be too high to avoid resetting the degree of crystallinity of the crystalline silicon region **205b** in the previous process step.

In this case, the crystallographic plane orientations of the crystalline silicon region **205e** thus obtained have already been almost determined in the solid-phase crystallization process step using the catalyst element. Specifically, the majority of the crystalline silicon region **205e** is comprised of a <111> zone. Among other things, (110) and (211) planes account for 50% or more of all crystal planes. And the crystalline silicon region **205e** consists of crystal domains that run in one direction (i.e., domains with substantially the same plane orientation) and is far from forming crystal grains. Likewise, the majority of the crystalline silicon region **204d** is comprised of a <111> zone, and (110) and (211) planes also account for 50% or more of all crystal planes. In the crystalline silicon region **204d,** however, crystal nuclei have been generated at random and crystal domains (with sizes of 1 µm to 3 µm) that are smaller than the crystalline silicon region **205e** have been produced. On the other hand, the crystalline silicon region 205f that has been crystallized from the amorphous state by being irradiated with the laser beam has random crystallographic plane orientations, which include a lot of (100) planes and (111) planes, in particular. Those (100) and (111) planes do not fall into the <111> zone. And the crystalline silicon region **205f** has an average crystal grain size of 100 nm to 300 nm.

Thereafter, excessive portions of the crystalline silicon regions **205e** and **205f** are removed, thereby electrically isolating two element regions from each other. In this process step, the crystalline silicon region **205e** with a high degree of crystallinity that has grown laterally is patterned into a semiconductor island **210t** to be the active region (including source/drain regions and a channel region) of a TFT and the crystalline silicon region **205f** is patterned into a semiconductor island **210d** to be the active region (including n⁺ and p⁺ regions and an intrinsic region) of a TFD as shown in FIG. **3(F)****.**

After that, a TFT and a TFD are completed by the same method as what has already been described for the first preferred embodiment by using these semiconductor islands 210t and **210d** as the respective active regions of the TFT and TFD. According to this preferred embodiment, a crystalline silicon film that has grown laterally to have an even higher degree of crystallinity can be used as a semiconductor layer to form part of a TFT, thus realizing a TFT with even higher current drivability. And the respective semiconductor layers of the TFT and TFD and the channel region of the TFT and the intrinsic region of the TFD can have their degrees of crystallinity optimized independently of each other. As a result, the device characteristics of the TFT and TFD can be optimized at the same time by using a single semiconductor layer obtained by crystallizing the same amorphous semiconductor film.

### (EMBODIMENT 3)

Hereinafter, a method for fabricating a semiconductor device as a third specific preferred embodiment of the present invention will be described. Specifically, it will be described how to fabricate a pixel TFT and its storage capacitor for use as a unit of display, a TFT circuit with a CMOS configuration for use as a driver, and a photosensor TFD at the same time on a glass substrate. The semiconductor device of this preferred embodiment can be used as an active-matrix-addressed liquid crystal display device including a built-in photosensor or an organic EL display device, for example.

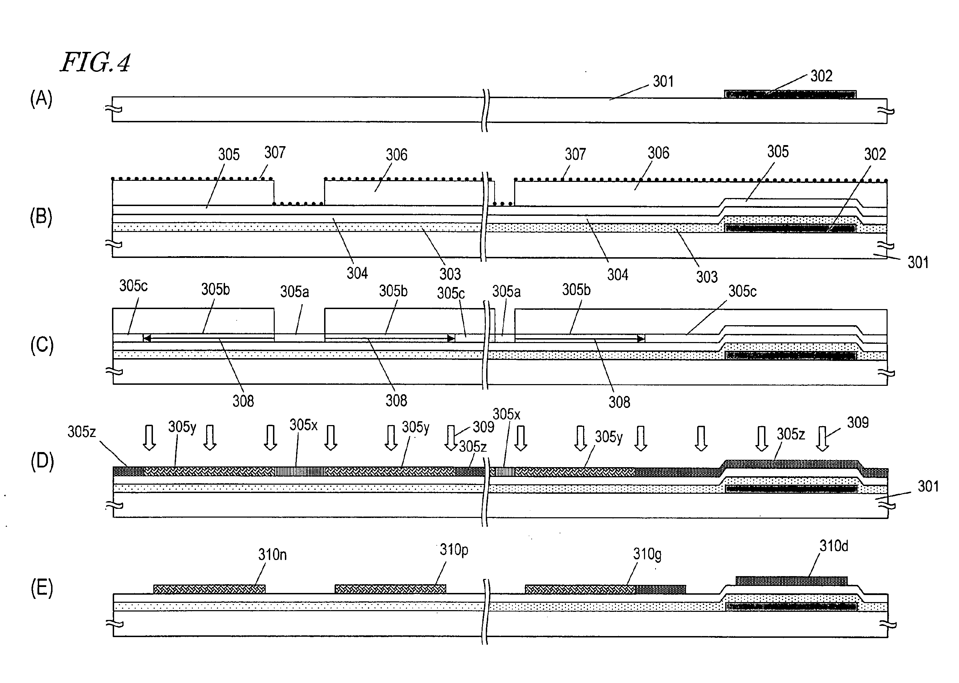

FIGS. **4** to **6** are cross-sectional views illustrating the respective process steps to fabricate an n-channel thin-film transistor and a p-channel thin-film transistor to form a driver circuit, an n-channel thin-film transistor to drive a pixel electrode, a storage capacitor connected to the n-channel transistor, and a thin-film diode as a photosensor. These process steps are carried out in the same order that these drawings (i.e., from FIG. **4(A)** through **6(K)****)** are arranged.

First, as shown in FIG. **4(A)****,** a metal film or a silicon film that will function as an opaque layer that shields the TFD from light coming from under the back surface of the substrate is formed on the surface of a glass substrate **301** on which a TFT and a TFD will be fabricated. In this preferred embodiment, a molybdenum (Mo) film is deposited as the metal film by sputtering process and then patterned, thereby forming the opaque layer **302.** In this process step, the Mo film may have a thickness of 30 nm to 300 nm (preferably in the range of 50 nm to 200 nm) and has a thickness of 100 nm in this preferred embodiment.

Next, as shown in FIG. **4(B)****,** undercoat films of silicon dioxide, silicon nitride or silicon oxynitride, for example, are deposited by plasma CVD process, for example, on the glass substrate **301** and on the opaque layer **302** to prevent impurities from diffusing from the glass substrate. In this preferred embodiment, a silicon nitride film is deposited to a thickness of approximately 100 nm as the lower, first undercoat film **303,** and then a silicon dioxide film is deposited as the second undercoat film **304** to a thickness of approximately 200 nm. Next, an intrinsic (I-type) amorphous silicon film (a-Si film) **305** is deposited to a thickness of approximately 20-80 nm (e.g., 40 nm) by plasma CVD process, for example. Furthermore, another silicon dioxide film or silicon nitride film is deposited to a thickness of 50-400 nm (e.g., 150 nm) and then patterned into a masking film **306** with an opening. The amorphous silicon film **305** is exposed through the opening of the masking film **306.**

Thereafter, a catalyst element is added to the surface of the amorphous silicon film **305.** Specifically, the surface of the amorphous silicon film **305** is coated with an aqueous solution including approximately 30 ppm by weight of catalyst element **307** (e.g., nickel in this preferred embodiment) such as an aqueous solution of nickel acetate by spin coating process, thereby forming a catalyst element containing layer. The catalyst element **307** selectively contacts with the amorphous silicon film **305** inside the opening of the masking film **306,** thereby defining a catalyst element added region. This is the state shown in FIG. **4(B)****.**

The catalyst element(s) is/are preferably one or multiple elements selected from the group consisting of iron (Fe), cobalt (Co), tin (Sn), lead (Pb), palladium (Pd) and copper (Cu) as well as nickel (Ni). Although their catalyst effects are lower than those of the former elements, ruthenium (Ru), rhodium (Rh), osmium (Os), iridium (Ir), platinum (Pt) or gold (Au) may also serve as a catalyst element. The dose of the catalyst element to be added in this process step is very small. And the concentration of the catalyst element at the surface of the amorphous silicon film **305** is controlled by total reflection X-ray fluorescence (TRXRF) analysis. In this preferred embodiment, the catalyst element has a concentration of approximately 5×10¹² atoms/cm². Optionally, before this process step is performed, the surface of the amorphous silicon film **305** may be slightly oxidized with ozone water, for example, to increase the wettability at the surface of the amorphous silicon film **305** during the spin-coating process.

In this preferred embodiment, nickel is-supposed to be introduced by spin coating process. However, a thin film of a catalyst element (e.g., a nickel film in this preferred embodiment) may be formed on the amorphous silicon film 305 by evaporation process or sputtering process, for example.

Subsequently, as shown in FIG. **4(C)****,** the substrate is thermally treated and crystallized within an inert atmosphere (e.g., a nitrogen gas ambient). The substrate is preferably annealed at a temperature of 550 to 620°C for one to four hours. In this preferred embodiment, the substrate was thermally treated at 600°C for two hours, as an example.

As a result of this heat treatment, where the catalyst element makes direct contact, the nickel atoms that have been added as the catalyst element to the surface of the amorphous silicon film **305** diffuse through the amorphous silicon film **305** and also produce silicides, thereby crystallizing the amorphous silicon film **305** using those silicides as nuclei of crystal growth. Consequently, the amorphous silicon film **305** gets crystallized in that region to be a crystalline silicon region **305a.** After that, the crystallization further progresses substantially parallel to the substrate (i.e., in the direction indicated by the arrow **308**) from the crystalline silicon region **305a** that has already been crystallized, thereby defining a crystalline silicon region **305b** of which the crystal growing directions are substantially uniform macroscopically, as shown in FIG. **4(C)****.** Meanwhile, the nickel atoms on the masking film **306** are prevented by the masking film **306** from reaching the underlying amorphous silicon film. Therefore, the amorphous silicon film **305** gets crystallized only by the nickel atoms introduced through the opening of the masking film **306.** Also, the region in which the lateral crystal growth has never occurred remains amorphous silicon region **305c.** Although the crystallization process is produced in this preferred embodiment by heat treatment process using a furnace, the crystallization may also be produced with a rapid thermal annealing (RTA) system that uses a lamp as a heat source.

Next, after the masking film (i.e., the silicon dioxide film) **306** has been removed, the entire surface of the substrate **301** is irradiated with the laser beam **309** as shown in FIG. **4(D)****.** That is to say, the crystalline silicon region **305a** that has been crystallized with the catalyst element directly added, the crystalline silicon region **305b** that has grown laterally, and the amorphous silicon region **305c** that has not been reached by the lateral crystal growth are all irradiated with the laser beam **309.** As a result, the crystalline silicon regions **305a** and **305b,** which have been selectively crystallized with the catalyst element introduced, have had their crystal imperfections reduced by going through the melting and solidification process, including irradiation with the laser beam **309,** and have been re-crystallized using their parts as nuclei of crystal growth to be crystalline silicon regions **305x** and **305y** of even higher quality. The crystalline silicon region **305y** in which crystals have grown laterally has also had its degree of crystallinity increased to be a crystalline silicon film with an even higher degree of crystallinity. On the other hand, the amorphous silicon region **305c** also gets crystallized by going through the melting and solidification process, including irradiation with the laser beam **309,** to be a crystalline silicon region **305z.**

In this process step, an XeCl excimer laser beam (with a wavelength of 308 nm) or a KrF excimer laser beam (with a wavelength of 248 nm) may be used as the laser beam. Also, in this process step, the sizes of the laser beam spot are determined so that an elongated beam spot is formed on the surface of the substrate **301.** And by sequentially scanning the surface of the substrate **301** perpendicularly to the direction in which the beam spot is elongated, the crystalline silicon film gets re-crystallized over the entire surface of the substrate. In this case, if the surface is scanned so that the beam spots partially overlap with each other, an arbitrary point on the crystalline silicon regions **305a** and **305b** and the amorphous region **305c** will be irradiated with the laser beam multiple times, thus contributing to increasing the uniformity. In this preferred embodiment, the sizes of the beam spot are determined so that the beam spot has an elongated shape of 300 mm × 0.4 mm on the surface of the substrate **301** and the substrate is sequentially scanned at a step of 0.02 mm perpendicularly to the direction in which the beam spot is elongated. That is to say, any arbitrary point on the silicon film gets irradiated with the laser beam 20 times in total. Examples of laser beams that can be used in this process step include KrF and XeCl excimer laser beams of pulsed or continuous wave type described above but also a YAG laser beam or a YVO4 laser beam as well.

Thereafter, excessive portions of the crystalline silicon regions **305x, 305y** and **305z** are removed, thereby electrically isolating two element regions from each other. In this process step, the crystalline silicon region **305y** in which crystals have grown laterally with the catalyst element added is patterned into a semiconductor island **310n** to be the active region (including source/drain regions and a channel region) of an n-channel TFT to form a driver circuit eventually and a semiconductor island **310p** to be the active region (including source/drain regions and a channel region) of a p-channel TFT as shown in FIG. **4(E)****.** Furthermore, the crystalline silicon region **305z** defined by crystallizing the amorphous region with the laser beam is patterned into another semiconductor island **310d** to be the active region (i.e., the n⁺ or p⁺ region or intrinsic region) of a photosensor TFD. As for the semiconductor island **310g** to be the active region (i.e., source/drain region or channel region) of the n-channel TFT that drives a pixel electrode and the lower electrode of the storage capacitor connected to the n-channel TFT, the region to be the active region of the TFT is defined by patterning the crystalline silicon region **305y** and the region to be the lower electrode of the storage capacitor is defined by patterning the crystalline silicon region **305z.** That is to say, there are two different kinds of crystalline regions **305y** and **305z** in a part of the semiconductor layer **310g.**

Optionally, some or all of these semiconductor layers may be doped with boron (B) as a p-type dopant in a concentration of approximately 1×10¹⁶/cm³ to 5×10¹⁷/cm³ to control the threshold voltage. Boron (B) may be introduced either when the ion doping process is performed or when an amorphous silicon film is deposited.

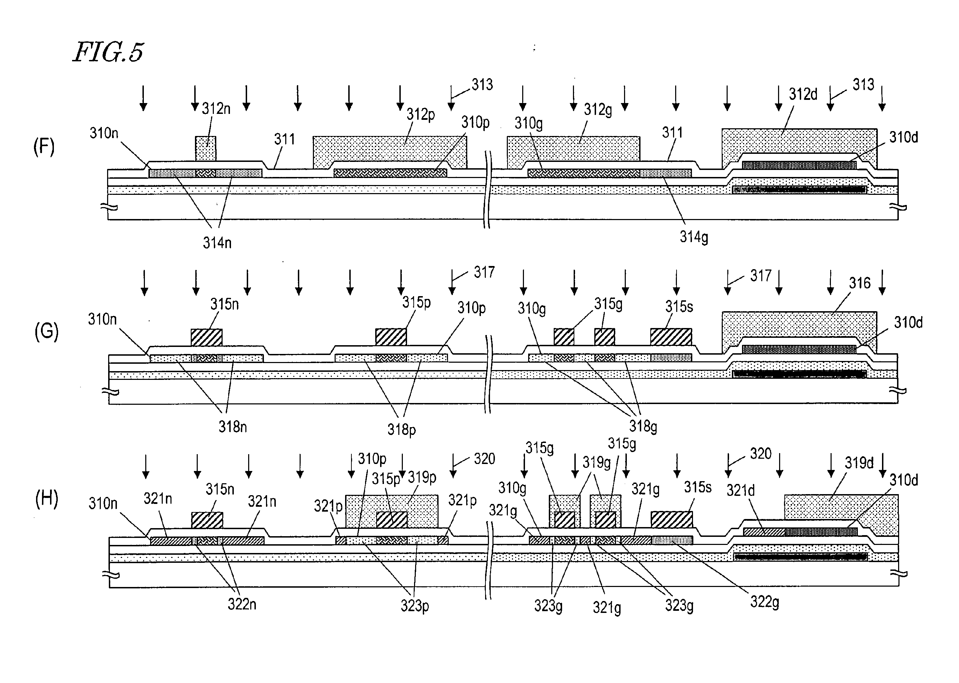

Next, as shown in FIG. **5(F)****,** a gate insulating film **311** is formed and an n-type dopant (e.g., phosphorus) **313** is introduced. First of all, a silicon dioxide film is deposited to a thickness of 20 nm to 150 nm (e.g., 100 nm in this preferred embodiment) as the gate insulating film **311** over those semiconductor layers **310n, 310p, 310g** and **310d** to be respective active regions. To make the silicon dioxide film, in this preferred embodiment, TEOS (tetraethoxy orthosilicate) is used as a source material and decomposed and deposited with oxygen by performing an RF plasma CVD process with the substrate heated to a temperature of 150°C to 600 °C (preferably at a temperature of 300°C to 450°C). Alternatively, also using TEOS as a source material and ozone gas, the silicon dioxide film may also be deposited by performing either a low pressure CVD process or an ordinary pressure CVD process with the substrate heated to a temperature of 350°C to 600 °C (preferably a temperature of 400°C to 550 °C). Optionally, after the silicon dioxide film has been deposited, the substrate may also be annealed for one to four hours at a temperature of 500°C to 600°C within an inert gas atmosphere in order to improve the bulk property of the gate insulating film itself or the property of the interface between the crystalline silicon film and the gate insulating film. Still alternatively, any other insulating film with silicon, having either a single layer structure or a multilayer structure, may also be used as the gate insulating film **311.**

Subsequently, photoresist masks **312n, 312p, 312g** and **312d** are formed over the semiconductor islands **310n, 310p, 310g** and **310d,** respectively. In this process step, the semiconductor layer **310n** to be the active region of an n-channel TFT has both ends thereof exposed with only its center portion (to be the channel region) masked with the photoresist mask **312n.** The semiconductor layer **310g** to be the active region of a pixel TFT and the lower electrode of a storage capacitor has its portion to be the active region of the pixel TFT masked with the photoresist mask **312g** but has its portion to be the lower electrode of the storage capacitor exposed. On the other hand, the semiconductor layer **310p** to be the active region of a p-channel TFT and the semiconductor layer **310d** to be the active region of a TFD are entirely covered with the photoresist masks **312p** and **312d,** respectively.

In such a state, the semiconductor islands **310n** and **310g** are implanted with dopant (phosphorus) ions **313** lightly by performing an ion doping process using the photoresist masks **312n, 312p, 312g** and **312d** as masks. In this process step, phosphine (PH₃) is used as a doping gas, the accelerating voltage is defined within the range of 60 kV to 90 kV (e.g., 70 kV), and the dose is defined within the range of 5 ×10¹² cm⁻² to 5×10¹⁴ cm⁻² (e.g., 5×10¹³cm⁻²). As a result of this process step, those portions of the semiconductor islands **310n** and **310g** that are not covered with the photoresist masks **312n** and **312g** are lightly doped with phosphorus ions **313** and turn into n-type light doped regions **314n** and **314g,** respectively. On the other hand, the phosphorus ions **313** are not implanted into the regions covered with the photoresist masks **312n** and **312g.** Likewise, the semiconductor islands **310p** and **310d** are entirely masked with the photoresist masks **312p** and **312d,** and therefore, are not doped with phosphorus ions **313** at all, either.

Next, as shown in FIG. **5(G)****,** a refractory metal is deposited by sputtering process to form a conductor film, which is then patterned into the shapes of gate electrodes **315n, 315p** and **315g** and the upper electrode **315s** of a storage capacitor. In this process step, that portion to be the pixel TFT's gate electrode **315g** is split into two in order to reduce the amount of leakage current to flow through the pixel TFT in OFF state and has a dual-gate structure in which two TFTs are connected in series together. Alternatively, the pixel TFT may have an even greater number of gate electrodes **315g** (or a greater number of TFTs connected in series together), which form either a triple gate structure or a quad-gate structure.

The refractory metal to deposit in this process step may be selected from the group consisting of elements tantalum (Ta), tungsten (W), molybdenum (Mo) and titanium (Ti), alloys including any of these elements as main ingredient, and alloys including a combination of these elements (such as an Mo-W alloy and an Mo-Ta alloy). Alternatively, tungsten silicide, titanium silicide or molybdenum silicide may also be used. In this preferred embodiment, tungsten (W) was deposited as a conductor film with a thickness of 300 nm to 600 nm (e.g., 450 nm). In this process step, the concentrations of impurities in the conductor film are preferably as low as possible to reduce the resistivity. For example, by decreasing the oxygen concentration to 30 ppm or less, a resistivity of 20 µΩ cm or less is realized.

Next, a doping mask **316** of photoresist is formed in a size that is big enough to easily cover the semiconductor layer **310d,** which will form part of a photosensor TFD, with some margin left, and the semiconductor regions to be respective TFT active regions are implanted with dopant (phosphorus) ions **317** lightly again by performing an ion doping process using the gate electrodes **315n, 315p** and **315g** and the upper electrode **315s** of a storage capacitor as masks. In this process step, phosphine (PH₃) is used as a doping gas, the accelerating voltage is defined within the range of 60 kV to 90 kV (e.g., 70 kV), and the dose is defined within the range of 1×10¹²cm⁻² to 1×10¹⁴ cm⁻² (e.g., 2×10¹³cm⁻²). As a result of this process step, those portions of the semiconductor islands **310n, 310p** and **310g** that are not covered with the gate electrodes **315n, 315p** and **315g** or the upper electrode **315s** of the storage capacitor are lightly doped with phosphorus ions **317** for the second time and turn into n-type light doped regions **318n, 318p** and **318g,** respectively. On the other hand, the dopant ions **317** are not implanted at all into the regions covered with the gate electrodes **315n, 315p** and **315g** and the upper electrode **315s** of the storage capacitor. This is the state shown in FIG. **5(G)****.**

Next, after the photoresist mask **316** has been stripped, a doping mask **319g** of photoresist is formed in a size that is big enough to easily cover the portion to be a pixel TFT's gate electrode **315p** with some margin left as shown in FIG. **5(H)****.** In addition, another doping mask **319p** of photoresist is also formed in a size that is big enough to easily cover the portion to be a p-channel TFT's gate electrode **315p** with some margin left so as to expose the outer periphery of the semiconductor layer **310p.** Furthermore, still another doping mask **319d** of photoresist is formed in a size that is big enough to easily cover the portion to be a photosensor TFD with some margin left and to partially expose the semiconductor layer **310d.** Thereafter, the respective semiconductor layers are implanted with dopant (phosphorus) ions **320** heavily by performing an ion doping process using that portion to be the n-channel TFT's gate electrode **315n,** that portion to be the storage capacitor's upper electrode **315s,** and the photoresist masks **319p, 319g** and **319d** as masks. In this process step, phosphine (PH₃) is used as a doping gas, the accelerating voltage is defined within the range of 60 kV to 90 kV (e.g., 70 kV), and the dose is defined to fall within the range of 1×10¹⁵ cm⁻² to 1×10¹⁶ cm⁻² (e.g., 5×10¹⁵ cm⁻²).

As a result of this process step, in the semiconductor layer **310n** to form part of an n-channel TFT, regions that are not covered with the gate electrode **315n** to be are heavily doped with dopant (phosphorus) atoms **320,** thereby defining regions to be n-channel TFT's source/drain regions **321n** that are self-aligned with the gate electrode **315n** to be. On the other hand, other regions of the same semiconductor layer **310n,** which have been covered with the gate electrode **315n** to be and have not been heavily doped with phosphorus atoms **320** but which were lightly doped with phosphorus atoms in the previous process step, will be so-called "GOLD (gate overlapped lightly doped drain)" regions **322n** overlapped with the gate electrode **315n.** Meanwhile, still another region of the semiconductor layer **310n** that is located under the gate electrode **315n** to be and that has not been lightly doped with phosphorus atoms, either, will be a channel region **328n.** These LDD regions can not only reduce the overconcentration of an electric field in the junctions between the channel region and the source/drain regions but also minimize deterioration to be caused by hot carriers. As a result, the reliability of an n-channel TFT in the driver circuit can be increased significantly.

The same can be said about the pixel TFT. That is to say, in the semiconductor layer **310g,** regions that are not covered with the photoresist mask **319g** are heavily doped with dopant (phosphorus) atoms **320,** thereby defining regions to be pixel TFT's (i.e., n-channel TFT's) source/drain regions **321g.** On the other hand, other regions of the same semiconductor layer **310g,** which have been covered with the photoresist mask **319g** and have not been heavily doped with phosphorus atoms **320** but which were lightly doped with phosphorus atoms in the previous process step, will be LDD regions **323g.** Meanwhile, still another region of the semiconductor layer **310g** that is located under the gate electrode **315g** to be and that has not been lightly doped with phosphorus atoms, either, will be a channel region **328g.** By forming such an LDD structure that has been offset outward under the gate electrode, the amount of leakage current to flow through the TFT in OFF state can be reduced significantly.

In the semiconductor layer **310p** to form part of a p-channel TFT, regions that are not covered with the photoresist mask **319p** are heavily doped with dopant (phosphorus) atoms **320,** thereby defining n-type heavily doped regions **321p.** On the other hand, another region of the semiconductor layer **310p** that is covered with the photoresist mask **319p** and that has been lightly doped with phosphorus ions **317** will be left as it is. Likewise, in the semiconductor layer **310d** to form part of a photosensor TFD, regions that are not covered with the photoresist mask **319d** are heavily doped with dopant (phosphorus) atoms **320,** thereby defining n-type heavily doped regions **321d.** In this process step, the in-film concentrations of the n-type dopant element (phosphorus) **320** in these regions **321n, 321p, 321g** and **321d** are in the range of 1×10¹⁹/cm³ to 1×10²¹/cm³. Meanwhile, in the GOLD region **322n** of the n-channel TFT, the in-film concentration of the n-type dopant element (phosphorus) **313** is in the range of 5×10¹⁷/cm³ to 1×10¹⁹/cm³. And in the LDD region **323g** of the pixel TFT, the in-film concentration of the n-type dopant element (phosphorus) **317** is in the range of 1×10¹⁷/cm³ to 5×10¹⁸/cm³. In other words, if the dopant concentrations fall within these ranges, those regions will function effectively as either GOLD or LDD regions.

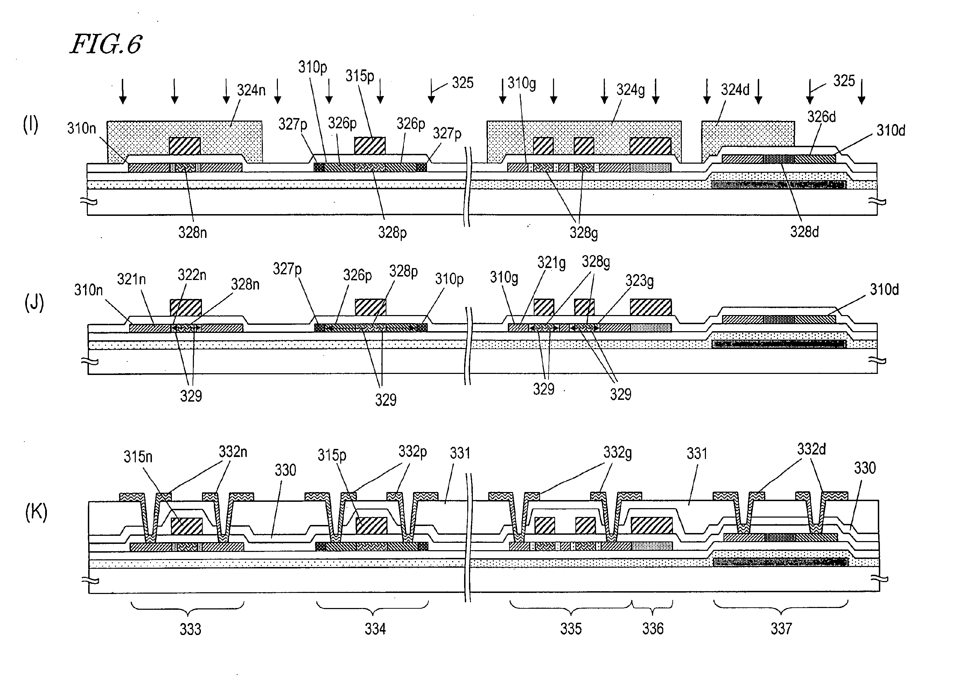

Next, after the photoresist masks **319p, 319g** and **319d** have been removed, doping masks **324n, 324g** and **324d** of photoresist are formed again to cover entirely the semiconductor layer **310n** to form part of the n-channel TFT and the semiconductor layer **310g** to form part of the pixel TFT and its storage capacitor and to cover partially the semiconductor layer **310d** to form part of the TFD as shown in FIG. **6(I)****.** And the semiconductor layers **310p** and **310d** to form respective parts of the p-channel TFT and the TFD are implanted with dopant (boron) ions **325** to make them p-type by performing an ion doping process using the photoresist masks **324n, 324g** and **324d** and the portion to be the p-channel TFT's gate electrode **315p** as masks. In this process step, diborane (B₂H₆) is used as a doping gas, the accelerating voltage is defined within the range of 40 kV to 90 kV (e.g., 75 kV), and the dose is defined to fall within the range of 1×10¹⁵ cm⁻² to 1×10¹⁶ cm⁻² (e.g., 3×10¹⁵ cm⁻²).

As a result of this process step, the semiconductor layer **310p** to form part of the p-channel TFT is heavily doped with boron atoms **325** except the region under the gate electrode-to-be **315p.** Also, as a result of this process step, the n-type dopant (phosphorus) **317** that has been introduced lightly in the previous process step into the region **323p** has its conductivity type inverted into p-type, thereby turning the region **323p** into TFT's source/drain regions **326p,** which are self-aligned with the gate electrode **315p.** Meanwhile, the region **321p** is doped heavily with not just phosphorus **320** in the previous process step but also boron **325** in this process step and will eventually function as a gettering region **327p.** On the other hand, the region under the gate electrode-to-be **315p** is not heavily doped with boron but will be channel region **328p.**

Furthermore, as for the semiconductor layer **310d** to form part of a photosensor TFD, the region not covered with the photoresist mask **324d** is heavily doped with boron **325** to turn into a p-type region **326d** to form part of the TFD. On the other hand, the region that has been masked with the photoresist mask **324d** and then the photoresist mask **319d** in the previous process step and that has been heavily doped with neither phosphorus nor boron will be the TFD's intrinsic region **328d.** In this process step, the in-film concentrations of the p-type dopant element (boron) **325** in the regions **326p, 326d,** and **327p** are within the range of 1.5 × 10¹⁹/cm³ to 3 × 10²¹/cm³. In this process step, the semiconductor layer **310n** to be an n-channel TFT and the semiconductor layer **310g** to be a pixel TFT and the lower electrode of its storage capacitor are entirely covered with the masks **324n** and **324g** and are not doped with boron **325** at all.

Thereafter, the photoresist masks **324n, 324g** and **324d** are removed and then the substrate is thermally treated within an inert atmosphere (e.g., a nitrogen gas ambient). In this preferred embodiment, an RTA process is carried out so that the temperature of the substrate is raised or lowered instantaneously by loading substrates one after another into a high-temperature atmosphere and spraying a high-temperature nitrogen gas against the surface of the substrate. The heat treatment process was carried out at a temperature rise/fall rate exceeding 200°C per minute (e.g., at 650°C for 10 minutes). In this process step, any other type of heat treatment may also be carried out and its conditions may also be defined appropriately by the person who carries out the process. It is naturally possible to carry out a normal heat treatment process using a diffusion furnace or an RTA process that uses a lamp. As a result of this heat treatment process, the phosphorus atoms that have been introduced into the portions of the semiconductor layers **310n** and **310g** to be the source/drain regions **321n** and **321g** of an n-channel TFT and a pixel switching thin-film transistor will increase the concentration of nickel solid solution in those regions, thereby moving the nickel atoms from the channel regions **328n** and **328g** to the source/drain regions by way of the GOLD or LDD region **322n** or **323g** in the directions indicated by the arrows **329** as shown in FIG. **6(J)****.** Meanwhile, in the semiconductor layer **310p** to form part of the p-channel TFT, the phosphorus and boron atoms that have been heavily introduced into the gettering regions **327p** outside of the source/drain regions and the lattice defects caused while boron was introduced also move the nickel atoms from the channel regions **328p** to the source/drain regions **326p** and then to the gettering regions in the directions indicated by the arrows **329.** Since the nickel atoms have come into the source/drain regions **321n** and **321g** to form parts of the n-channel TFT and pixel TFT and into the gettering regions **327p** of the p-channel TFT and TFD as a result of the heat treatment process, the concentrations of nickel in those regions become equal to or higher than 1 × 10¹⁸/cm³.

On top of that, as a result of this heat treatment process, also activated are the n-type dopant (phosphorus) atoms that have been introduced into the source/drain regions **321n** and **321g,** GOLD region **322n,** LDD regions **323g** and the storage capacitor's lower electrode region **322g** to form parts of the n-channel TFT and pixel TFT and into the n-type region **321d** to form part of the TFD and the p-type dopant (boron) atoms that have been introduced into the source/drain regions **326p** to form part of the p-channel TFT and into the p-type region **326d** to form part of the TFD. Consequently, the source/drain regions of the n-channel TFT and the pixel TFT and the n-type region of the TFD had a sheet resistance of approximately 0.5 to 1 kΩ/□ and the GOLD region thereof and the storage capacitor's lower electrode had a sheet resistance of approximately 20 to 60 kΩ/□. And the LDD region had a sheet resistance of approximately 40 to 100 kΩ/□. On the other hand, the source/drain regions of the p-channel TFT and the p-type region of the TFD had a sheet resistance of approximately 0.7 to 1.2 kΩ/□.In the gettering regions, the n-type dopant (phosphorus) atoms and p-type dopant (boron) atoms introduced cancel the carriers (including electrons and holes) and come to have a sheet resistance of several ten kΩ/□, which is not high enough to make them function as source/drain regions. However, these gettering regions are arranged so as not to interfere with the drift of the carriers in the semiconductor layers to form parts of the p-channel TFT and will cause no problem at all.

Subsequently, as shown in FIG. **6(K)****,** silicon nitride, silicon dioxide or silicon oxynitride is deposited as an interlevel dielectric film **331** to a thickness of 400 nm to 1,500 nm (typically in the range of 600 nm to 1,000 nm). In this preferred embodiment, the interlevel dielectric film **331** has a dual layer structure consisting of a silicon nitride film **330** with a thickness of 200 nm and a silicon dioxide film **331** with a thickness of 700 nm. In this process step, the interlevel dielectric film is deposited continuously by plasma CVD process using SiH₄ and NH₃ as source gases to make the silicon nitride film and TEOS and O₂ to make the silicon dioxide film, respectively. Naturally, the interlevel dielectric film does not have to have this structure but may also be either a single- or multilayer structure including any other insulating film with silicon. And if necessary, an organic insulating film such as an acrylic film may be deposited as the top layer.

Furthermore, a heat treatment process is carried out at a temperature of 300°C to 500 °C for 30 minutes to 4 hours to hydrogenate the semiconductor layers. This is a process step for terminating and inactivating dangling bonds, which would deteriorate the characteristics of a TFT, by supplying hydrogen atoms to the interface between the active regions and the gate insulating film. In this preferred embodiment, the heat treatment was conducted at 400°C for an hour within a nitrogen gas ambient including approximately 3% of hydrogen. If the interlevel dielectric film (e.g., the silicon nitride film **330,** in particular) includes sufficient hydrogen, then even a heat treatment within the nitrogen gas ambient will be effective enough. Alternatively, the semiconductor layers may also be hydrogenated by plasma hydrogenation process (that uses hydrogen excited by plasma).

Next, contact holes are cut through the interlevel dielectric film and metallic materials (such as a stack of titanium nitride and aluminum) are deposited and patterned into electrodes and interconnects **332n, 332p, 332g** and **332d** for TFTs. The titanium nitride film is provided as a barrier film that prevents aluminum from diffusing into the semiconductor layers. Finally, the structure thus obtained is annealed at 350°C for an hour, thereby completing an n-channel thin-film transistor **333** and a p-channel thin-film transistor **334** to make a driver, a pixel switching thin-film transistor **335,** a storage capacitor **336** connected to the transistor **335,** and a photosensor thin-film diode **337** as shown in FIG. **6(K)****.** In the pixel TFT, a transparent conductor film of ITO, for example, is connected to one of the two pairs of electrodes and interconnects **332g** to form a pixel electrode. If necessary, contact holes may also be cut over the gate electrodes **315n** and **315p** and the electrodes may be connected together with the interconnects **332** as needed. Optionally, to protect the TFTs, a passivation film of silicon nitride may also be deposited over those TFTs.

The TFTs fabricated by the process of the preferred embodiment described above had very good characteristics. Specifically, the n-channel TFT had as high a field effect mobility as 250 cm²/Vs to 300 cm²/Vs with a threshold voltage of approximately 1 V, while the p-channel TFT had as high a field effect mobility as 120 cm²/Vs to 150 cm²/Vs with a threshold voltage of approximately 1.5 V. Also, when a circuit such as an inverter chain or a ring oscillator was formed of CMOS circuit elements in which the n- and p-channel TFTs of the preferred embodiment described above were arranged complementarily, the circuit achieved a higher degree of reliability and more stabilized circuit characteristics. Furthermore, the dark current value of the TFD could also be reduced to one-fifth or less, and the brightness to darkness ratio as a photosensor unit could be increased five times or more, compared to a situation where the TFD and a TFT were fabricated on the same substrate by conventional process. And by forming those different types of semiconductor layers for respective elements independently of each other, the respective device characteristics could be optimized.

### (EMBODIMENT 4)

Hereinafter, a method for fabricating a semiconductor device according to a fourth preferred embodiment of the present invention will be described. Specifically, in this preferred embodiment, a semiconductor layer to be the active region of a pixel TFT for use as a unit of display and the lower electrode of its storage capacitor, semiconductor layers to be n- and p-channel TFTs that form a TFT circuit with a CMOS configuration for use as a driver, and a semiconductor layer to be a photosensor TFD are formed at the same time on a glass substrate by a different method from the one adopted in the third preferred embodiment.

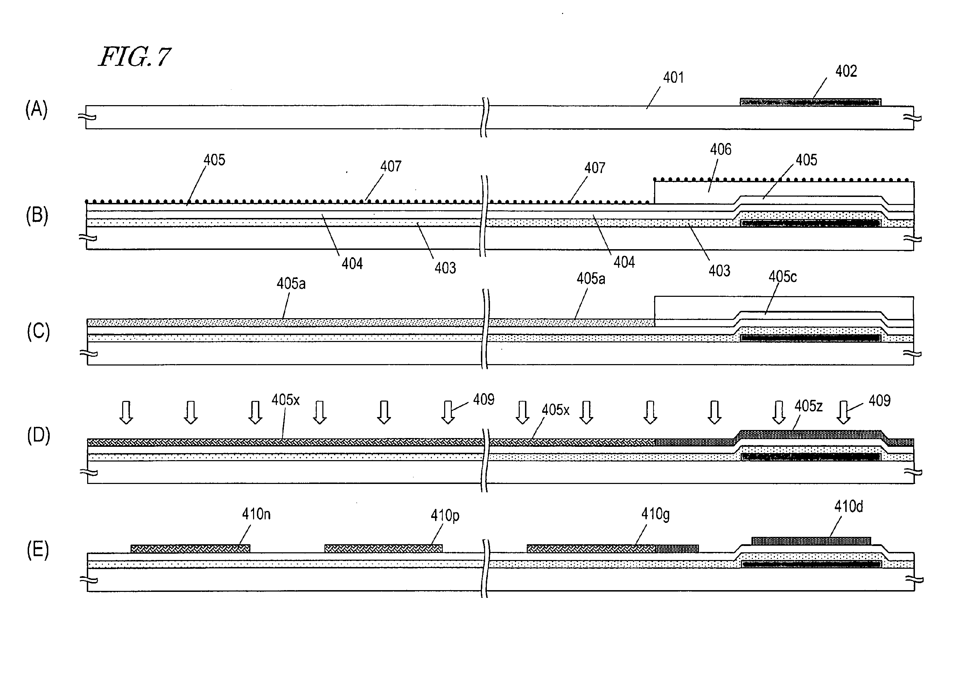

FIGS. **7 (A)** through **7(E)** are cross-sectional views illustrating the respective process steps to fabricate the TFTs and TFD of this preferred embodiment. These process steps are carried out in the same order that these portions (A) through (E) of FIG. **7** are arranged.

First, as shown in FIG. **7(A)****,** an opaque layer **402** that shields the TFD from the light coming from under the back surface of the substrate is formed on the surface of a glass substrate **401** on which a TFT and a TFD will be fabricated.

Next, as shown in FIG. **7(B)****,** a silicon nitride film is deposited as the lower, first undercoat film **403** over the glass substrate **401** and the opaque layer **402,** and then a-second undercoat film **404** of silicon dioxide is deposited thereon as in the third preferred embodiment described above. Next, an intrinsic (i-type) amorphous silicon film **405** is deposited to a thickness of approximately 50 nm by plasma CVD process or any other suitable process. Thereafter, either a silicon dioxide film or a silicon nitride film is deposited and then patterned into a masking film **406** with an opening. The amorphous silicon film **405** is exposed through the opening of this masking film **406.**

Thereafter, a catalyst element **407** is added to the surface of the amorphous silicon film **405** and the masking film **406** by the same method as the one adopted in the third preferred embodiment. Specifically, using nickel as the catalyst element **407,** a catalyst element containing layer is formed. In this process step, the catalyst element **407** selectively contacts with the amorphous silicon film **405** at the opening of the masking film **406,** thereby defining a catalyst element added region there. This is the state shown in FIG. **7(B)****.**

Subsequently, the substrate is thermally treated within an inert atmosphere (e.g., a nitrogen gas ambient), thereby crystallizing the amorphous silicon film **405** as shown in FIG. **7(C)****.** As a result of this heat treatment, at the opening of the masking film **406,** the amorphous silicon film **405** is crystallized into a crystalline silicon film **405a** using, as a catalyst, the nickel atoms that have been added to the surface of the amorphous silicon film **405.** The nickel atoms on the masking film **406** are prevented by the masking film **406** from reaching the underlying amorphous silicon film but will remain as an amorphous silicon region **405c.** In this manner, the amorphous silicon film **405** can be crystallized with only the nickel that has been added through the opening.

Next, after the masking film (i.e., the silicon dioxide film) **406** has been removed, the entire surface of the substrate **401** is irradiated with the laser beam **409** as shown in FIG. **7(D)** by the same method as the one adopted in the third preferred embodiment. That is to say, the region **405a** that has been crystallized with the catalyst element directly added and the amorphous silicon region **405c** that has been masked are all irradiated with the laser beam **409.** As a result, the crystalline silicon region **405a,** which has been selectively crystallized with the catalyst element introduced, has had its crystal imperfections reduced by going through the melting and solidification process, including irradiation with the laser beam **409,** and have been re-crystallized using its part as nuclei of crystal growth to be a crystalline silicon region **405x** of even higher quality. On the other hand, the amorphous silicon region **405c** also gets crystallized by going through the melting and solidification process, including irradiation with the laser beam **409,** to be a crystalline silicon region **405z.**

Thereafter, excessive portions of the crystalline silicon regions **405x** and **405z** are removed, thereby electrically isolating two element regions from each other as shown in FIG. **7(E)****.** In this process step, the crystalline silicon region **405x** that has been crystallized with the catalyst element added is patterned into a semiconductor island **410n** to be the active region (including source/drain regions and a channel region) of an n-channel TFT to form a driver circuit eventually and a semiconductor island **410p** to be the active region (including source/drain regions and a channel region) of a p-channel TFT. Furthermore, the crystalline silicon region **405z** defined by crystallizing the amorphous region with the laser beam is patterned into another semiconductor island **410d** to be the active region (i.e., the n⁺ or p⁺ region or intrinsic region) of a photosensor TFD. As for the semiconductor island **410g** to be the active region (i.e., source/drain region or channel region) of the n-channel TFT that drives a pixel electrode and the lower electrode of the storage capacitor connected to the n-channel TFT, the region to be the active region of the TFT is defined by patterning the crystalline silicon region **405x** and the region to be the lower electrode of the storage capacitor is defined by patterning the crystalline silicon region **405z.** That is to say, there are two different kinds of crystalline regions in a part of the semiconductor layer **410g.**

After that, respective TFTs and TFD are completed by using the semiconductor island **410n** as the active region of an n-channel TFT, the semiconductor island **410p** as the active region of a p-channel TFT, a region **405x** of the semiconductor island **410g** that has been crystallized with the catalyst element as the pixel TFT's active region, a region **405y** of the semiconductor layer **410g** that has been crystallized by being irradiated with a laser beam as the lower electrode of the storage capacitor, and the semiconductor island **410d** as the active region of a TFD, respectively.

### (EMBODIMENT 5)

Hereinafter, a method for fabricating a semiconductor device according to a fifth preferred embodiment of the present invention will be described. Specifically, in this preferred embodiment, a semiconductor layer to be the active region of a pixel TFT for use as a unit of display and the lower electrode of its storage capacitor, semiconductor layers to be n- and p-channel TFTs that form a TFT circuit with a CMOS configuration for use as a driver, and a semiconductor layer to be a photosensor TFD are formed at the same time on a glass substrate by a different method from the ones adopted in the third and fourth preferred embodiments described above.

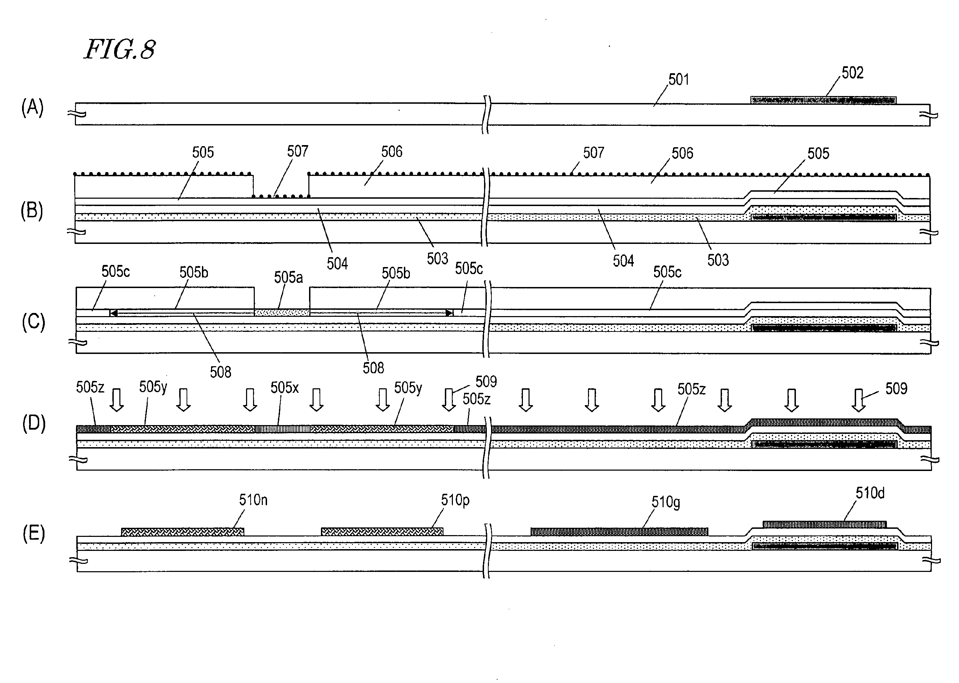

FIGS. **8(A)** through **8(E)** are cross-sectional views illustrating the respective process steps to fabricate the TFTs and TFD of this preferred embodiment. These process steps are carried out in the same order that these portions (A) through (E) of FIG. **8** are arranged.

First, as shown in FIG. **8(A)****,** an opaque layer **502** that shields the TFD from the light coming from under the back surface of the substrate is formed on the surface of a glass substrate **501** on which a TFT and a TFD will be fabricated.

Next, as shown in FIG. **8(B)****,** a silicon nitride film is deposited as the lower, first undercoat film **503** over the glass substrate **501** and the opaque layer **502,** and then a second undercoat film **504** of silicon dioxide is deposited thereon as in the third preferred embodiment described above. Next, an intrinsic (i-type) amorphous silicon film **505** is deposited to a thickness of approximately 50 nm by plasma CVD process or any other suitable process.

Thereafter, as shown in FIG. **8(B)****,** either a silicon dioxide film or a silicon nitride film is deposited and then patterned into a masking film **506** with an opening. The amorphous silicon film **505** is exposed through the opening of this masking film **506.**

Subsequently, a catalyst element **507** is added to the surface of the amorphous silicon film **505** and the masking film **506** by the same method as the one adopted in the third preferred embodiment. Specifically, using nickel as the catalyst element **507,** a catalyst element containing layer is formed. The catalyst element **507** selectively contacts with the amorphous silicon film **505** inside the opening of the masking film **506,** thereby defining a catalyst element added region. This is the state shown in FIG. **8(B)****.**

Subsequently, as shown in FIG. **8(C)****,** the substrate is thermally treated within an inert atmosphere (e.g., a nitrogen gas ambient), thereby crystallizing the amorphous silicon film **505.** As a result of this heat treatment process, inside the opening of the masking film **506,** the amorphous silicon film **505** is crystallized with nickel added to the surface of the amorphous silicon film as a catalyst and turns into a crystalline silicon film **505a.** Meanwhile, the crystallization progresses substantially parallel to the substrate (i.e., in the direction indicated by the arrow **508**) from the crystalline silicon region **505a** that has already been crystallized, thereby defining a crystalline silicon region **505b,** of which the crystal growing directions are substantially uniform macroscopically. Meanwhile, the nickel atoms on the masking film **506** are prevented by the masking film **506** from reaching the underlying amorphous silicon film. Therefore, the amorphous silicon film **505** gets crystallized only by the nickel atoms introduced through the opening. Also, the region in which the lateral crystal growth has never occurred remains amorphous silicon region **505c.**

Next, after the masking film (i.e., the silicon dioxide film) **506** has been removed, the entire surface of the substrate is irradiated with the laser beam **509** as shown in FIG. **8(D)** as in the third preferred embodiment described above. That is to say, the region **505a** that has been crystallized with the catalyst element directly added, the crystalline silicon region **505b** that has grown laterally from that region **505a** as a seed crystal, and the amorphous silicon region **505c** that has been masked are all irradiated with the laser beam **509.** As a result, the crystalline silicon regions **505a** and **505b,** which have been selectively crystallized with the catalyst element introduced, have had their crystal imperfections reduced by going through the melting and solidification process, including irradiation with the laser beam **509,** and have been re-crystallized using their parts as nuclei of crystal growth to be crystalline silicon regions **505x** and **505y** of even higher quality. On the other hand, the amorphous silicon region **505c** also gets crystallized by going through the melting and solidification process, including irradiation with the laser beam **509,** to be a crystalline silicon region **505z.**

Thereafter, excessive portions of the crystalline silicon regions **505x, 505y** and **505z** are removed, thereby electrically isolating two element regions from each other as shown in FIG. **8(E)****.** In this process step, the crystalline silicon region **505y** with a high degree of crystallinity in which crystals have grown laterally with the catalyst element added is patterned into a semiconductor island **510n** to be the active region (including source/drain regions and a channel region) of an n-channel TFT to form a driver circuit eventually and a semiconductor island **510p** to be the active region (including source/drain regions and a channel region) of a p-channel TFT. Furthermore, the crystalline silicon region **505z** defined by crystallizing the amorphous region with the laser beam is patterned into another semiconductor island **510d** to be the active region (i.e., the n⁺ or p⁺ region or intrinsic region) of a photosensor TFD and another semiconductor island **510g** to be the active region (i.e., source/drain region or channel region) of the n-channel TFT that drives a pixel electrode and the lower electrode of the storage capacitor connected to the n-channel TFT.

After that, as in the third preferred embodiment described above, respective TFTs and TFD are completed by using the semiconductor island **510n** as the active region of an n-channel TFT, the semiconductor island **510p** as the active region of a p-channel TFT, the semiconductor island **510g** as the active region of the pixel TFT and the lower electrode of the storage capacitor, and the semiconductor island **510d** as the active region of a TFD, respectively.

According to this preferred embodiment, the active region of the pixel TFT is defined out of a semiconductor layer that has been crystallized by irradiating an amorphous silicon film with a laser beam directly without adding any catalyst element thereto, unlike the preferred embodiments of the present invention described above. As a result, TFTs with a CMOS configuration to form a driver circuit can have high field effect mobility and high drivability, and the pixel TFT can have a reduced amount of leakage current in its OFF state. On the other hand, the TFD can have a reduced amount of dark current and will achieve a high bright current to dark current ratio for a photosensor. As a result, by using a semiconductor layer that has been obtained by crystallizing the same amorphous semiconductor film, the TFT and the TFD can achieve their best device performances required.

Also, as described above, this preferred embodiment is effectively applicable to an organic EL display device. For example, if a transparent electrode layer, a light emitting layer and an upper electrode layer are deposited in this order over the substrate on which a thin-film transistor and a thin-film diode have been formed by the method described above, a bottom-emission type organic EL display device can be fabricated. Alternatively, a top-emission type organic EL display device may also be fabricated by forming a transparent electrode as the upper electrode layer. In that case, the substrate does not have to be light transmissive.

### (EMBODIMENT 6)

Hereinafter, a semiconductor device as a sixth specific preferred embodiment of the present invention will be described. The semiconductor device of this preferred embodiment is a display device with a sensor function. Such a display device is fabricated on a substrate on which a TFT and a TFD have been formed by the method of any of the preferred embodiments of the present invention described above.

A display device with a sensor function according to this preferred embodiment may be a liquid crystal display device with a touchscreen sensor, which includes a display area and a frame area surrounding the display area. The display area includes a plurality of display units (i.e., pixels) and a plurality of photosensor units. Each display unit includes a pixel electrode and a pixel switching TFT. Each photosensor unit includes a TFD. The frame area has a display driver to drive the respective display units, and driver TFTs are used to form the driver. The pixel switching TFTs, the driver TFTs and the photosensor unit TFDs have been integrated together on the same substrate by the method of any of the first through fifth preferred embodiments of the present invention described above. It should be noted that among those TFTs for use in the display device of the present invention, at least the pixel switching TFTs and the photosensor unit TFDs should be formed on the same substrate by the method described above. Thus, the driver, for example, may be arranged on another substrate.

According to this preferred embodiment, each photosensor unit is arranged adjacent to its associated display unit (e.g., a pixel representing a primary color). In this case, either a single photosensor unit or multiple photosensor units may be provided for a single display unit. Alternatively, one photosensor unit may be provided for a set of multiple display units. For example, one photosensor unit may be provided for a set of three color display pixels, which may be pixels representing the three primary colors of R, G and B. In this manner, the number (or the density) of photosensor units with respect to that of display units may be appropriately selected according to the resolution.

If color filters were arranged closer to the viewer than the photosensor units are, then the sensitivity of the TFDs that form the photosensor units might decrease. That is why it is preferred that no color filters be arranged closer to the viewer than the photosensor units are.

It should be noted that the display device of this preferred embodiment does not have to have the configuration described above. For example, if the photosensor TFDs are arranged in the frame area, the display device can also function as an ambient sensor that can control the screen brightness according to the illuminance of the external light. Alternatively, if color filters are arranged closer to the viewer than the photosensor units are so that the incoming light is transmitted through the color filters and then received at the photosensor units, the photosensor units can function as a color image sensor.

Hereinafter, a display device according to this preferred embodiment will be described as being applied to a touchscreen panel LCD with a touchscreen panel sensor.

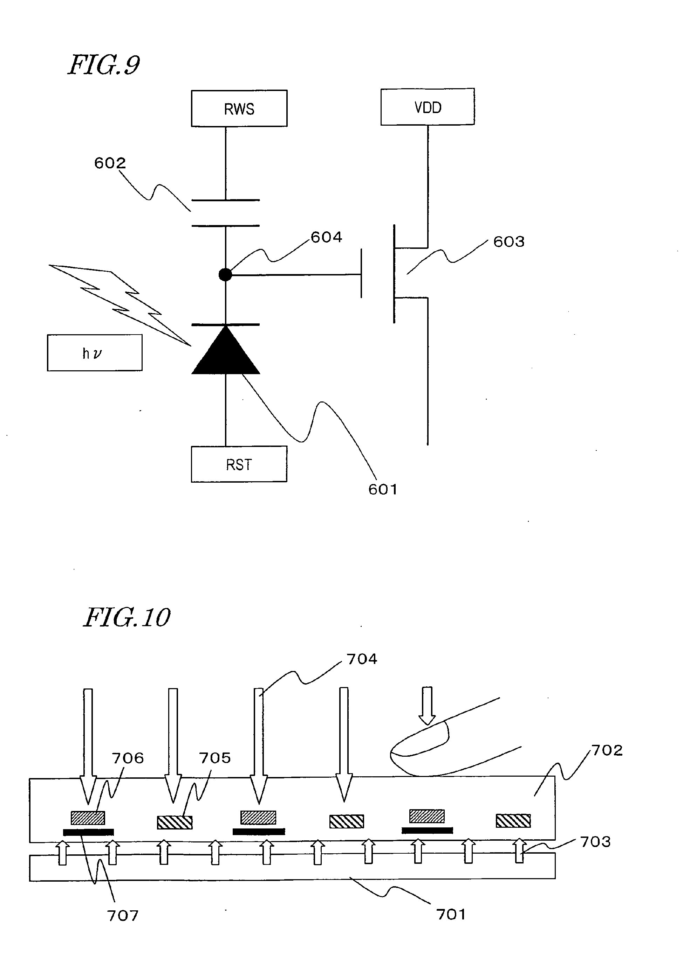

FIG. **9** is a circuit diagram illustrating a configuration for a photosensor unit to be arranged in the display area. The photosensor unit includes a photosensor thin-film diode **601,** a signal storage capacitor **602,** and a thin-film transistor **603** for retrieving the signal stored in the capacitor **602.** After an RST signal has been received and after an RST potential has been written at a node **604,** the potential at the node **604** decreases due to the leakage current produced by the incoming light. Then, the gate potential of the thin-film transistor **603** varies to open or close the TFT gate. In this manner, a signal **VDD** can be retrieved.

FIG. **10** is a schematic cross-sectional view illustrating an example of an active-matrix-addressed touchscreen panel LCD. In this example, a photosensor unit is provided for each pixel.

The LCD shown in FIG. **10** includes a liquid crystal module **702** and a backlight **701,** which is arranged behind the liquid crystal module **702.** Although not shown in FIG. **10****,** the liquid crystal module **702** includes a light transmissive rear substrate, a front substrate that is arranged to face the rear substrate, and a liquid crystal layer interposed between those two substrates. The liquid crystal module **702** includes a number of display units (i.e., pixels representing the primary colors), each of which includes a pixel electrode (not shown) and a pixel switching thin-film transistor **705** that is connected to the pixel electrode. Also arranged adjacent to each display unit is a photosensor unit including a thin-film diode **706.** Although not shown in FIG. **10****,** either, color filters are arranged closer to the viewer over each display unit but not over any photosensor unit. An opaque layer **707** is arranged between the thin-film diodes **706** and the backlight **701.** Thus, the light that has come from the backlight **701** is cut off by the opaque layer **707** and not incident on any thin-film diode **706,** which is supposed to be struck by only external light **704.** By getting this incoming external light **704** sensed by the thin-film diodes **706,** a photosensing type touchscreen panel is realized. It should be noted that the opaque layer **707** has only to be arranged so that the light that has come from the backlight **701** does not enter the intrinsic region of any thin-film diode **706.**

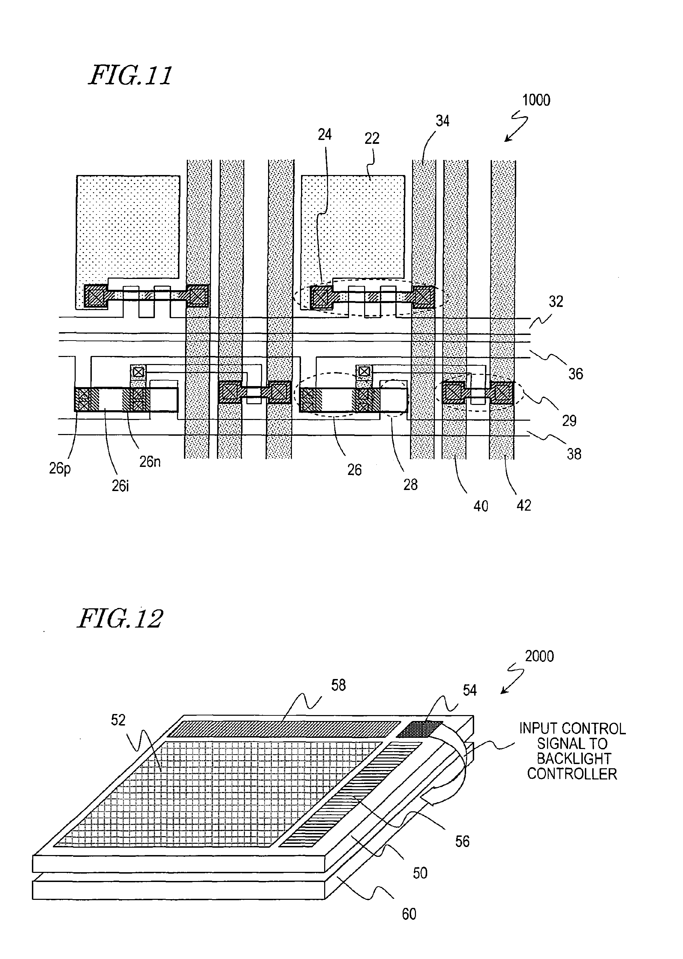

FIG. **11** is a schematic plan view illustrating an exemplary rear substrate for use in the active-matrix-addressed touchscreen panel LCD. The LCD of this preferred embodiment is actually made up of a huge number of pixels (including R, G and B pixels). But only two of those pixels are shown in FIG. **11** for the sake of simplicity.

The rear substrate **1000** includes a number of display units (i.e., pixels), each including a pixel electrode **22** and a pixel switching thin-film transistor **24,** and a number of photosensor units, each of which is arranged adjacent to an associated one of the display units and which includes a photosensor photodiode **26,** a signal storage capacitor **28,** and a photosensor follower thin-film transistor **29.**

The thin-film transistor **24** may have the same structure as the TFT that has already been described for the third preferred embodiment, i.e., a dual-gate LDD structure including two gate electrodes and an LDD region. The thin-film transistor **24** has its source region connected to a pixel source bus line **34** and has its drain region connected to the pixel electrode **22.** The thin-film transistor **24** is turned ON and OFF in response to a signal supplied through a pixel gate bus line **32.** With such an arrangement, the pixel electrode **22** and a counter electrode on the front substrate that is arranged to face the rear substrate 1000 apply a voltage to the liquid crystal layer, thereby varying the orientation state of the liquid crystal layer and getting a display operation done.

On the other hand, the photosensor diode **26** may have the same configuration as the TFD that has already been described for the third preferred embodiment, and has a p⁺-type region **26p,** an n⁺-type region **26n** and an intrinsic region **26i** arranged between these two regions **26p** and **26n.** The signal storage capacitor **28** uses a gate electrode layer and an Si layer as electrodes, and forms capacitance in its gate insulating film. The photosensor diode **26** has its p⁺-type region **26p** connected to a photosensor RST signal line **36** and has its n⁺-type region **26n** connected to the lower electrode (Si layer) of the signal storage capacitor **28** and to a photosensor RWS signal line **38** by way of the capacitor **28.** The n⁺-type region **26n** is further connected to the gate electrode layer of the photosensor follower thin-film transistor **29,** of which the source and drain regions are connected to a photosensor VDD signal line **40** and a photosensor COL signal line **42,** respectively.

As described above, the photosensor photodiode **26,** the signal storage capacitor **28,** and the photosensor follower thin-film transistor **29** respectively correspond to the thin-film diode **701,** capacitor **702** and thin-film transistor **703** of the driver shown in FIG. **10** and together form a photosensor driver. Hereinafter, it will be described how this driver performs a photosensing operation.

(1) First of all, through the RWS signal line **38,** a RWS signal is written on the signal storage capacitor **28.** As a result, a positive electric field is generated in the n⁺-type region **26n** of the photosensor photodiode **26** and a reverse bias will be applied to the photosensor photodiode **26.** (2) Next, photo-leakage current is produced in the photosensor photodiodes **26** in a surface region of the substrate that is irradiated with light, thus moving the electrical charges toward the RST signal line **36.** (3) As a result, the potential decreases in the n⁺-type region **26n** and that potential variation in turn causes a variation in the gate voltage applied to the photosensor follower thin-film transistor **29.** (4) A VDD signal is supplied through the VDD signal line **40** to the source electrode of the photosensor follower thin-film transistor **29.** When the gate voltage varies as described above, the amount of the current flowing through the COL signal line **42** that is connected to the drain electrode changes. Thus, the electrical signal representing that current can be output through the COL signal line **42.** (5) And through the COL signal line **42,** an RST signal is written on the photosensor photodiode **26,** thereby resetting the potential at the signal storage capacitor **28.** By performing this series of processing steps (1) through (5) a number of times while getting scanning done, photosensing can be carried out.

In the touchscreen panel LCD of this preferred embodiment, the rear substrate does not always have to have the configuration shown in FIG. **11****.** Optionally, a storage capacitor **Cs** may be provided for each pixel switching TFT, for example. In the example illustrated in FIG. **11****,** a photosensor unit is arranged adjacent to each of the R, G and B pixels. Alternatively, one photosensor unit may be provided for a set of three color display pixels (i.e., R, G and B pixels) just as described above.

Now take a look at FIG. **10** again. In the example described above, the thin-film diodes **706** are arranged in the display area and used as a touchscreen sensor as can be seen from the cross-sectional view illustrated in FIG. **10****.** Alternatively, the thin-film diodes **706** may also be arranged outside of the display area and may be used as an ambient sensor for controlling the luminance of the backlight **701** according to the illuminance of the external light **704.**

FIG. **12** is a perspective view illustrating an LCD with an ambient light sensor. The LCD **2000** includes an LCD substrate **50** including a display area **52,** a gate driver **56,** a source driver **58** and a photosensor section **54,** and a backlight **60,** which is arranged behind the LCD substrate **50.** A portion of the LCD substrate **50,** which surrounds the display area **52** and which includes the drivers **56** and **58** and the photosensor section **54,** will be referred to herein as a "frame area".

The luminance of the backlight **60** is controlled by a backlight controller (not shown). Although not shown, the display area **52** and the drivers **56** and **58** use TFTs and the photosensor section **54** uses TFDs. The photosensor section **54** generates an illuminance signal representing the illuminance of the external light and enters it into the backlight controller using connection with a flexible substrate. In response to the illuminance signal, the backlight controller generates a backlight control signal and outputs it to the backlight **60.**

Optionally, by applying the present invention, an organic EL display device with an ambient light sensor can also be provided. Such an organic EL display device may also have a configuration including display units and photosensor units on the same substrate just like the LCD shown in FIG. **12** but does not need to have the backlight **60** behind the substrate. In that case, the photosensor section **54** is connected to the source driver **58** with a cable provided for the substrate **50** so that the illuminance signal is supplied from the photosensor section **54** to the source driver **58.** In response to that illuminance signal, the source driver **58** adjusts the luminance of the display area **52.**

While the present invention has been described with respect to specific preferred embodiments thereof, it will be apparent to those skilled in the art that the disclosed invention may be modified in numerous ways and may assume many embodiments other than those specifically described above as long as those modifications fall within the true spirit and scope of the invention. For example, by using the TFTs of the present invention, analog drivers and digital drivers may be fabricated on a glass substrate at the same time. Examples of those analog drivers include a source driver, a pixel section and a gate driver. The source driver may include a shift register, a buffer and a sampling circuit (transfer gate). On the other hand, the gate driver may include a shift register, a level shifter and a buffer. Also, if necessary, a level shifter circuit may be provided between the sampling circuit and the shift register. Furthermore, according to the manufacturing process of the present invention, a memory and a microprocessor may also be fabricated.

The present invention provides a semiconductor device including high-performance TFTs and TFDs that have been fabricated on the same substrate using their best semiconductor films. As a result, TFTs with high field effect mobility and ON/OFF ratio, which can be used as driver TFTs and pixel electrode switching TFTs, and TFDs that will have a low dark current value when used as photosensors and a high SNR with respect to the incoming light (i.e., a high bright current to dark current ratio), can be fabricated by performing the same series of manufacturing processing steps using a semiconductor layer obtained by crystallizing the same amorphous semiconductor film as their respective active regions. Among these semiconductor layers, if their portions to be the channel region that will have significant influence on the field effect mobility of TFTs and the intrinsic region that will have great impact on the photosensitivity of TFDs are optimized, the respective semiconductor components can achieve their best device performances required. Furthermore, such high-performance semiconductor components are provided by performing a simple manufacturing process, and a product of a smaller size and with improved performance can be provided at a reduced cost.

### INDUSTRIAL APPLICABILITY

The present invention has a broad variety of applications and is applicable to any kind of semiconductor device with TFTs and TFDs and to an electronic device in any field that uses such a semiconductor device. For example, a CMOS circuit and a pixel section fabricated by carrying out the present invention may be used in an active-matrix-addressed liquid crystal display device and an organic EL display device. Such a display device may be used as either the display screen of a cellphone or a portable game console or the monitor of a digital camera. Consequently, the present invention is applicable to any kind of electronic device including a built-in LCD or organic EL display device.

The present invention can be used particularly effectively in an active-matrix-addressed LCD, an organic EL display device, an image sensor, a photosensor, and an electronic device including any of these devices in combination. It would be particularly beneficial to apply the present invention to a display device with a photosensor function that uses TFDs or an electronic device with such a display device. Optionally, the present invention is also applicable to an image sensor including a photosensor that uses a TFD and a driver that uses a TFT.

### REFERENCE SIGNS LIST

**101, 201** substrate
**102, 202** opaque layer
**103, 203, 104, 204** undercoat film
**105, 205** amorphous semiconductor film
**106, 206** masking film
**107, 207** catalyst element
**105a, 205a, 205b** crystalline silicon region (catalyst-aided crystallized region)
**105b, 205d, 205e** crystalline silicon region (high crystallinity region)
**105c, 205f** crystalline silicon region (low crystallinity region)
**109t, 210t** thin-film transistor's semiconductor layer
**109d, 210d** thin-film diode's semiconductor layer
**110** gate insulating film
**111** gate electrode
**114** source/drain regions
**115** n-type region
**116** channel region
**119** p-type region
**124** electrodes and interconnects
**120** intrinsic region
**123** interlevel dielectric film
**125** electrodes and interconnects
**126** thin-film transistor
**127** thin-film diode

## Claims

1. A semiconductor device comprising a thin-film transistor and a thin-film diode, the thin-film transistor including a semiconductor layer that has a channel region, a source region and a drain region, a gate electrode that controls the conductivity of the channel region, and a gate insulating film arranged between the semiconductor layer and the gate electrode, the thin-film diode including a semiconductor layer that has at least an n-type region and a p-type region,
wherein the respective semiconductor layers of the thin-film transistor and the thin-film diode are portions of a single crystalline semiconductor layer obtained by crystallizing the same amorphous semiconductor film, and
wherein the semiconductor layer of the thin-film transistor does include a catalyst element that promotes crystallization of the amorphous semiconductor film, and
wherein the semiconductor layer of the thin-film diode includes substantially no catalyst elements.

2. The semiconductor device of claim 1, wherein the semiconductor layer of the thin-film diode is comprised mostly of crystals with (100) and/or (111) plane orientations.

3. The semiconductor device of claim 1, wherein the thin-film diode further has an intrinsic region that is defined between the n- and p-type regions of the semiconductor layer of the thin-film diode and that is comprised mostly of crystals with (100) and/or (111) plane orientations.

4. The semiconductor device of one of claims 1 to 3, wherein at least the channel region of the semiconductor layer of the thin-film transistor is comprised mostly of crystals, of which the plane orientations are defined by a <111> zone.

5. The semiconductor device of claim 4, wherein at least the channel region of the semiconductor layer of the thin-film transistor is comprised mostly of crystals with (110) and/or (211) plane orientations.

6. The semiconductor device of one of claims 1 to 5,
wherein at least the channel region of the semiconductor layer of the thin-film transistor is comprised of a group of columnar crystals, of which the crystal-growing direction is roughly parallel to the direction in which carriers move in the thin-film transistor.

7. The semiconductor device of one of claims 1 to 6,
wherein in the semiconductor layer of the thin-film transistor, the catalyst element is not deposited but included as a solid solution.

8. The semiconductor device of one of claims 1 to 7,
wherein in the semiconductor layer of the thin-film transistor, the concentration of the catalyst element is higher in the source or drain region than in the channel region.

9. The semiconductor device of one of claims 1 to 7,
wherein the thin-film transistor further has a gettering region, which is defined elsewhere in the semiconductor layer of the thin-film transistor so as not to overlap with the channel, source or drain region, and wherein the concentration of the catalyst element is higher in the gettering region than in the channel, source or drain region.

10. The semiconductor device of one of claims 1 to 9, wherein the thin-film transistor is a number of thin-film transistors including an n-channel thin-film transistor and a p-channel thin-film transistor.

11. The semiconductor device of one of claims 1 to 10, wherein the catalyst element is nickel.

12. A method for fabricating a semiconductor device, the method comprising the steps of:
(a) providing a substrate, of which the surface is covered with an amorphous semiconductor film;
(b) selectively adding a catalyst element, which promotes crystallization, to only a part of the amorphous semiconductor film;
(c) heating the amorphous semiconductor film, to which the catalyst element has been added selectively, thereby crystallizing that part of the amorphous semiconductor film to define a catalyst-aided crystallized region and leaving the rest of the amorphous semiconductor film as an amorphous region;
(d) irradiating the catalyst-aided crystallized region and the amorphous region with a laser beam, thereby obtaining a crystalline semiconductor film that has a high crystallinity region, which has been defined by either further crystallizing or re-crystallizing the catalyst-aided crystallized region, and a low crystallinity region, which has been defined by crystallizing the amorphous region; and
(e) patterning the crystalline semiconductor film into a first semiconductor island to define an active region for the thin-film transistor and a second semiconductor island to define an active region for the thin-film diode, the first semiconductor island including the high crystallinity region, the second semiconductor island including the low crystallinity region.

13. The method of claim 12, wherein the step (c) includes defining the catalyst-aided crystallized region by crystallizing that part of the amorphous semiconductor film to which the catalyst element has been added.

14. The method of claim 12, wherein the step (c) includes the steps of:
(c1) crystallizing that part of the amorphous semiconductor film, to which the catalyst element has been added, thereby defining a first catalyst-aided crystallized region; and
(c2) growing crystals laterally from the first catalyst-aided crystallized region, thereby defining a second catalyst-aided crystallized region around the first catalyst-aided crystallized region, and
wherein the step (d) includes the step of defining a first high crystallinity region by either further crystallizing or re-crystallizing the first catalyst-aided crystallized region and defining a second high crystallinity region by either further crystallizing or re-crystallizing the second catalyst-aided crystallized region, and
wherein in the step (e), the first semiconductor island includes the second high crystallinity region.

15. The method of one of claims 12 to 14, wherein the step (e) includes defining a portion of the first semiconductor island to be the channel region of a thin-film transistor out of the high crystallinity region of the crystalline semiconductor film.

16. The method of one of claims 12 to 15, wherein the step (e) includes defining a portion of the second semiconductor island to be the intrinsic region of a thin-film diode out of the low crystallinity region of the crystalline semiconductor film.

17. The method of one of claims 12 to 16, wherein the step (e) includes forming the first semiconductor island in
its entirety out of the high crystallinity region of the crystalline semiconductor film.

18. The method of one of claims 12 to 17, wherein the step (e) includes forming the second semiconductor island in its entirety out of the low crystallinity region of the crystalline semiconductor film.

19. The method of claim 14, wherein the step (e) includes defining at least partially a region of the first semiconductor island to be the source region and/or the drain region of a thin-film transistor out of the first high crystallinity region of the crystalline semiconductor film and defining a region of the first semiconductor island to be the channel region of the thin-film transistor out of the second high crystallinity region.

20. The method of one of claims 12 to 19, wherein the step (e) includes forming a semiconductor layer to be one of the two electrodes of a capacitor out of the low crystallinity region of the crystalline semiconductor film.

21. The method of one of claims 12 to 20, wherein the step (e) further includes forming another semiconductor island to be the active region of another thin-film transistor out of the low crystallinity region of the crystalline semiconductor film.

22. The method of one of claims 12 to 21, wherein the step (b) includes:
covering the amorphous semiconductor film with a mask that has an opening; and
adding the catalyst element to a selected region of the amorphous semiconductor film through the opening.

23. The method of one of claims 12 to 22, wherein the step (d) includes irradiating the catalyst-aided crystallized region and the amorphous region with a laser beam having such an energy density that is not so high as to totally reset the degree of crystallinity of the catalyst-aided crystallized region yet to be irradiated with the laser beam but is high enough to crystallize the amorphous region.

24. The method of one of claims 12 to 23, wherein the substrate transmits light, and
wherein the method further includes, before the step (a), forming an opaque layer for cutting off light that has come through the back surface of the substrate under a region of the substrate in which the second semiconductor island to be the active region of a thin-film diode will be formed.

25. The method of one of claims 12 to 23, further comprising the steps of:
(f) forming a gate insulating film that covers at least the first semiconductor island;
(g) forming a gate electrode on the gate insulating film that covers the first semiconductor island;
(h) doping portions of the first semiconductor island, which will be source and drain regions, with a dopant element;
(i) doping a portion of the second semiconductor island, which will be an n-type region, with an n-type dopant element; and
(j) doping another portion of the second semiconductor island, which will be a p-type region, with a p-type dopant element.
